# EUROPEAN PATENT APPLICATION

(11) **EP 4 583 149 A1**
(43) Date of publication of application: **09.07.2025**
(21) Application number: 23860255.1
(22) Date of filing: 28.08.2023
(51) Int. Cl.: H01L 21/02, C08K 5/00, C08L 33/06, C08L 33/12, C08L 61/10

(54) **RELEASE AGENT COMPOSITION FOR PHOTOIRRADIATION RELEASE, LAMINATE, AND METHOD FOR PRODUCING PROCESSED SEMICONDUCTOR SUBSTRATE**

(30) Priority: 29.08.2022 JP 2022135765
(71) Applicant: Nissan Chemical Corporation, Tokyo 103-6119 (JP)
(72) Inventor: FUKUDA, Takuya, Toyama-shi, Toyama 939-2792 (JP); SHINJO, Tetsuya, Toyama-shi, Toyama 939-2792 (JP)
(74) Representative: Hoffmann Eitle
(86) International application number: PCT/JP2023/030881
(87) International publication number: WO 2024/048493

(57) **Abstract**

There is provided a release agent composition for photoirradiation release, containing: a Novolac resin, a (meth)acrylic acid ester-based polymer, and a solvent.

## Description

### Technical Field

The present invention relates to a release agent composition for photoirradiation release, a laminate, and a method for producing a processed semiconductor substrate.

### Background Art

Conventionally, semiconductor wafers have been integrated in a two-dimensional planar direction. In order to achieve higher integration, it is required to employ a semiconductor integration technology that integrates (stacks) planar surfaces in a three-dimensional direction. This three-dimensional stacking is a technology that integrates multiple layers while connecting the layers using through silicon vias (TSV). When integrating multiple layers, each wafer to be integrated is thinned by polishing on the side opposite to the formed circuit surface (that is, the back surface), and the thinned semiconductor wafers are stacked.

A pre-thinned semiconductor wafer (also referred to herein simply as a wafer) is adhered to a support for polishing in a polishing apparatus. The adhesion at that time must be easily released after polishing, and thus the adhesion is referred to as temporary adhesion. This temporary adhesion must be easily removed from the support, and when a large force is applied to the removal, the thinned semiconductor wafer may be cut or deformed, and is easily removed such that such a situation does not occur. However, at the time of polishing the back surface of the semiconductor wafer, it is not preferable for the semiconductor wafer to become detached or displaced due to polishing stress. Therefore, the performance required for temporary adhesion is to withstand the stress at the time of polishing and to be easily removed after polishing.

For example, there is a demand for performance having a high stress (strong adhesive force) in the planar direction at the time of polishing and a low stress (weak adhesive force) in the longitudinal direction at the time of removal.

Although a method by laser irradiation has been disclosed (refer to, for example, Patent Literature 1 and 2.) for such an adhesion and separation process, a new technology related to releasing by irradiation of light such as a laser is always required with further progress in the recent semiconductor field.

The present applicant has proposed a laminate for processing a workpiece, the laminate including an intermediate layer adhered between a support and the workpiece to be releasable, in which the intermediate layer includes at least a release layer in contact with the support side, and the release layer includes a Novolac resin that absorbs light having a wavelength of 190 nm to 600 nm emitted through the support and undergoes a change in properties (refer to Patent Literature 3).

### Citation List

### Patent Literature

Patent Literature 1: JP 2004-64040 A
Patent Literature 2: JP 2012-106486 A
Patent Literature 3: WO 2019/088103 A

### Summary of Invention

### Technical Problem

The surface of a semiconductor substrate such as a semiconductor wafer may have irregularities due to bumps or the like. In general, the release agent layer is formed to have a thin thickness of approximately 200 nm, but it may be difficult to cover the irregularities of the semiconductor substrate with a thin release agent layer.

The present invention has been made in view of the above circumstances, and an object of the present invention is to provide a release agent composition for photoirradiation release capable of forming a thick release agent layer in a state where appearance, releasability, and cleanability are good, and a laminate, and a method for producing a processed semiconductor substrate using the release agent composition.

### Solution to Problem

The inventors have conducted intensive studies to solve the above-described problems. As a result, the inventors have found that the above-described problems can be solved and have completed the present invention having the following gist.

That is, the present invention includes the following.
[1] A release agent composition for photoirradiation release, containing:
   a Novolac resin, a (meth)acrylic acid ester-based polymer, and a solvent.
[2] The release agent composition according to [1], in which the (meth)acrylic acid ester-based polymer contains a repeating unit derived from a (meth)acrylic acid alkyl ester having 4 to 20 carbon atoms.
[3] The release agent composition according to [1] or [2], in which the (meth)acrylic acid ester-based polymer contains a repeating unit derived from methyl methacrylate.
[4] The release agent composition according to any one of [1] to [3], in which the (meth)acrylic acid ester-based polymer contains polymethyl methacrylate.
[5] The release agent composition according to any one of [1] to [4], in which the Novolac resin contains at least one of a structural unit represented by the following Formula (C1-1), a structural unit represented by the following Formula (1-2), and a structural unit represented by the following Formula (C1-3). 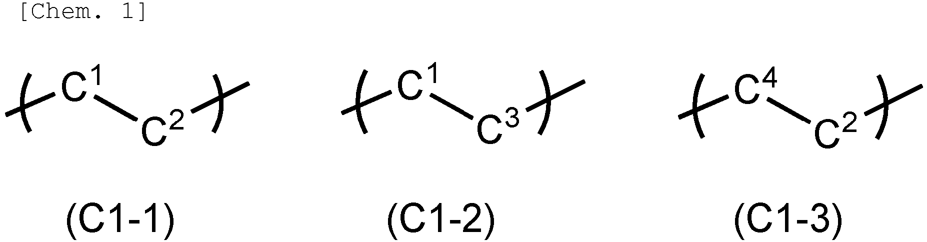 (In the formula, C¹ represents a group derived from an aromatic compound containing a nitrogen atom, C² represents a group containing a tertiary carbon atom or a quaternary carbon atom having at least one selected from a group consisting of a secondary carbon atom, a quaternary carbon atom, and an aromatic ring in a side chain, or represents a methylene group, C³ represents a group derived from an aliphatic polycyclic compound, and C⁴ represents a group derived from phenol, a group derived from bisphenol, a group derived from naphthol, a group derived from biphenyl, or a group derived from biphenol.)
[6] The release agent composition according to [5], in which the Novolac resin contains, as the structural unit represented by the Formula (C1-1), at least one of a structural unit represented by Formula (C1-1-1) below and a structural unit represented by Formula (C1-1-2) below. 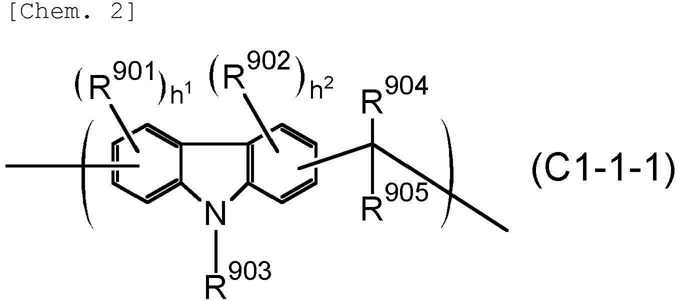 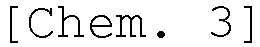 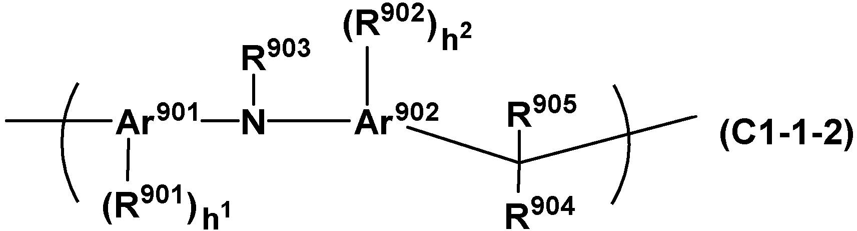
   (In the Formulas (C1-1-1) and (C1-1-2), R⁹⁰¹ and R⁹⁰² represent a substituent substituted with a ring, and each independently represent a halogen atom, a nitro group, a cyano group, an amino group, a hydroxy group, a carboxy group, an optionally substituted alkyl group, an optionally substituted alkenyl group, or an optionally substituted aryl group.
   R⁹⁰³ represents a hydrogen atom, an optionally substituted alkyl group, an optionally substituted alkenyl group, or an optionally substituted aryl group.
   R⁹⁰⁴ represents a hydrogen atom, an optionally substituted aryl group, or an optionally substituted heteroaryl group.
   R⁹⁰⁵ represents an optionally substituted alkyl group, an optionally substituted aryl group, or an optionally substituted heteroaryl group.
   The group of R⁹⁰⁴ and the group of R⁹⁰⁵ may be bonded to each other to form a divalent group.
   Ar⁹⁰¹ and Ar⁹⁰² each independently represent an aromatic ring.
   h¹ and h² each independently represent an integer of 0 to 3.)
[7] The release agent composition according to any one of [1] to [6], in which a content of the (meth)acrylic acid ester-based polymer is 35% by mass or more with respect to a total of the Novolac resin and the (meth)acrylic acid ester-based polymer.
[8] A laminate including:
   a semiconductor substrate or an electronic device layer;
   a light-transmissive support substrate; and
   a release agent layer provided between the semiconductor substrate or the electronic device layer and the support substrate, wherein
   the release agent layer is a release agent layer formed from the release agent composition according to any one of [1] to [7].
[9] The release agent composition according to [8], in which the release agent layer has a thickness of 0.5 µm to 10 µm.
[10] The laminate according to [8] or [9], further including an adhesive layer provided between the semiconductor substrate or the electronic device layer and the support substrate.
[11] The laminate according to any one of [8] to [10], in which the release agent layer is in contact with the semiconductor substrate.
[12] The laminate according to any one of [8] to [11], in which a surface of the semiconductor substrate on the support substrate side has a bump.
[13] A method for producing a processed semiconductor substrate or an electronic device layer, the method including:
   Step 5A of processing the semiconductor substrate of the laminate according to any one of [8] to [12], or Step 5B of processing the electronic device layer of the laminate according to any one of [8] to [12]; and
   Step 6A of separating the semiconductor substrate processed in the Step 5A and the support substrate from each other, or Step 6B of separating the electronic device layer processed in the Step 5B and the support substrate from each other.
[14] The method for producing a processed semiconductor substrate or an electronic device layer according to [13], in which the Step 6A or the Step 6B includes a step of irradiating the laminate with a laser from the support substrate side.

### Advantageous Effects of Invention

According to the present invention, it is possible to provide a release agent composition for photoirradiation release capable of forming a thick release agent layer in a state where appearance, releasability, and cleanability are good, and a laminate, and a method for producing a processed semiconductor substrate using the release agent composition.

### Brief Description of Drawings

Fig. 1 is a schematic cross-sectional view of an example of a laminate according to a first embodiment.
Fig. 2A is a schematic cross-sectional view for explaining a method for producing a laminate showing an example in the first embodiment (part 1).
Fig. 2B is a schematic cross-sectional view for explaining the method for producing a laminate showing an example in the first embodiment (part 2).
Fig. 2C is a schematic cross-sectional view for explaining the method for producing a laminate showing an example in the first embodiment (part 3).
Fig. 2D is a schematic cross-sectional view for explaining the method for producing a laminate showing an example in the first embodiment (part 4).
Fig. 2E is a schematic cross-sectional view for explaining the method for producing a laminate showing an example in the first embodiment (part 5).
Fig. 3 is a schematic cross-sectional view of an example of a laminate according to a second embodiment.
Fig. 4 is a schematic cross-sectional view of another example of the laminate according to the second embodiment.
Fig. 5A is a schematic cross-sectional view for explaining a method for producing a laminate showing an example in a second embodiment (part 1).
Fig. 5B is a schematic cross-sectional view for explaining the method for producing a laminate showing an example in the second embodiment (part 2).
Fig. 5C is a schematic cross-sectional view for explaining the method for producing a laminate showing an example in the second embodiment (part 3).
Fig. 5D is a schematic cross-sectional view for explaining the method for producing a laminate showing an example in the second embodiment (part 4).
Fig. 6A is a schematic cross-sectional view for explaining a method for processing a laminate showing an example in the first embodiment (part 1).
Fig. 6B is a schematic cross-sectional view for explaining the method for processing a laminate showing an example in the first embodiment (part 2).
Fig. 6C is a schematic cross-sectional view for explaining a method for processing a laminate showing an example in the first embodiment (part 3).
Fig. 7A is a schematic cross-sectional view for explaining a method for processing a laminate showing an example in the second embodiment (part 1).
Fig. 7B is a schematic cross-sectional view for explaining the method for processing a laminate showing an example in the second embodiment (part 2).
Fig. 7C is a schematic cross-sectional view for explaining a method for processing a laminate showing an example in the second embodiment (part 3).
Fig. 7D is a schematic cross-sectional view for explaining the method for processing a laminate showing an example in the second embodiment (part 4).
Fig. 7E is a schematic cross-sectional view for explaining a method for processing a laminate showing an example in the second embodiment (part 5).
Fig. 7F is a schematic cross-sectional view for explaining the method for processing a laminate showing an example in the second embodiment (part 6).

### Description of Embodiments

### (Release Agent Composition for Photoirradiation Release)

The release agent composition for photoirradiation release of the present invention contains a Novolac resin, a (meth)acrylic acid ester-based polymer, and a solvent.

The present inventors tried to form a thick release agent layer of approximately 1,500 nm using a release agent composition containing a Novolac resin and a solvent, but the coating property was poor, and cracking and liquid crawling occurred in the release agent layer to be formed, and the appearance was not good.

Therefore, the present inventors have studied using another resin (polymer) in combination with a release agent composition containing a Novolac resin and a solvent. As other resins, for example, (meth)acrylic acid ester-based polymers, polystyrene, polyhydroxystyrene, hydrogenated styrene-based thermoplastic elastomers, and the like were examined.

As a result, when a resin (polymer) other than the (meth)acrylic acid ester-based polymer was used in combination, a thick release agent layer having good appearance, releasability, and cleanability was not obtained. However, the present inventors have found that when a (meth)acrylic acid ester-based polymer is used in combination, a release agent layer having no problem in appearance, releasability, and cleanability can be obtained, and have completed the present invention.

### <Novolac Resin>

The Novolac resin is, for example, a resin obtained by condensation reaction of at least one of a phenolic compound, a carbazole compound, and an aromatic amine compound with at least one of an aldehyde compound, a ketone compound, and a divinyl compound under an acid catalyst.

Examples of the phenolic compound include phenols, naphthols, anthrols, hydroxypyrenes, and the like. Examples of the phenols include phenol, cresol, xylenol, resorcinol, bisphenol A, p-tert-butylphenol, p-octylphenol, 9,9-bis(4-hydroxyphenyl) fluorene, and 1,1,2,2-tetrakis(4-hydroxyphenyl) ethane. Examples of the naphthols include 1-naphthol, 2-naphthol, 1,5-dihydroxynaphthalene, 2,7-dihydroxynaphthalene, and 9,9-bis(6-hydroxynaphthyl) fluorene. Examples of the anthrols include 9-anthrol. Examples of the hydroxypyrenes include 1-hydroxypyrene and 2-hydroxypyrene.

Examples of the carbazole compound include carbazole, 1,3,6,8-tetranitrocarbazole, 3,6-diaminocarbazole, 3,6-dibromo-9-ethylcarbazole, 3,6-dibromo-9-phenylcarbazole, 3,6-dibromocarbazole, 3,6-dichlorocarbazole, 3-amino-9-ethylcarbazole, 3-bromo-9-ethylcarbazole, 4,4'bis(9H-carbazole-9-yl)biphenyl, 4-glycidylcarbazole, 4-hydroxycarbazole, 9-(1H-benzotriazole-1-ylmethyl)-9H-carbazole, 9-acetyl-3,6-diiodocarbazole, 9-benzoylcarbazole, 9-benzoylcarbazole-6-dicarboxyaldehyde, 9-benzylcarbazole-3-carboxyaldehyde, 9-methylcarbazole, 9-phenylcarbazole, 9-vinylcarbazole, carbazole potassium, carbazole-N-carbonyl chloride, N-ethylcarbazole-3-carboxaldehyde, and N-((9-ethylcarbazole-3-yl)methylene)-2-methyl-1-indolinylamine.

Examples of the aromatic amine compound include diphenylamine and N-phenyl-1-naphthylamine.

These solvents can be used alone or in combination of two or more thereof.

These may have a substituent. For example, these may have a substituent in the aromatic ring.

Examples of the aldehyde compound include saturated aliphatic aldehydes, unsaturated aliphatic aldehydes, heterocyclic aldehydes, and aromatic aldehydes. Examples of the saturated aliphatic aldehydes include formaldehyde, paraformaldehyde, acetaldehyde, propylaldehyde, butyraldehyde, isobutyraldehyde, valeraldehyde, capronaldehyde, 2-methylbutyraldehyde, hexylaldehyde, undecanaldehyde, 7-methoxy-3,7-dimethyloctylaldehyde, cyclohexanaldehyde, 3-methyl-2-butyraldehyde, 2-ethylhexylaldehyde, glyoxal, malonaldehyde, succinaldehyde, glutaraldehyde, and adipine aldehyde. Examples of the unsaturated aliphatic aldehydes include acrolein and methacrolein. Examples of the heterocyclic aldehydes include furfural and pyridine aldehyde. Examples of the aromatic aldehydes include benzaldehyde, naphthylaldehyde, anthrylaldehyde, phenanthrylaldehyde, salicylaldehyde, phenylacetaldehyde, 3-phenylpropionaldehyde, tolylaldehyde, (N,N-dimethylamino)benzaldehyde, and acetoxybenzaldehyde. Among them, saturated aliphatic aldehydes and aromatic aldehydes are preferable.

Examples of the ketone compound include a diaryl ketone compound. Examples of the diaryl ketone compound include diphenyl ketone, phenyl naphthyl ketone, dinaphthyl ketone, phenyl tolyl ketone, and ditolyl ketone.

Examples of the divinyl compound include divinylbenzene, dicyclopentadiene, tetrahydroindene, 4-vinylcyclohexene, 5-vinylnoborna-2-ene, divinylpyrene, limonene, and 5-vinylnorbornadiene.

These solvents can be used alone or in combination of two or more thereof.

The Novolac resin is, for example, a Novolac resin that absorbs light and undergoes a change in properties. The change in properties is, for example, photolysis.

The Novolac resin contains, for example, at least one of a structural unit represented by the following Formula (C1-1), a structural unit represented by the following Formula (1-2), and a structural unit represented by the following Formula (C1-3).

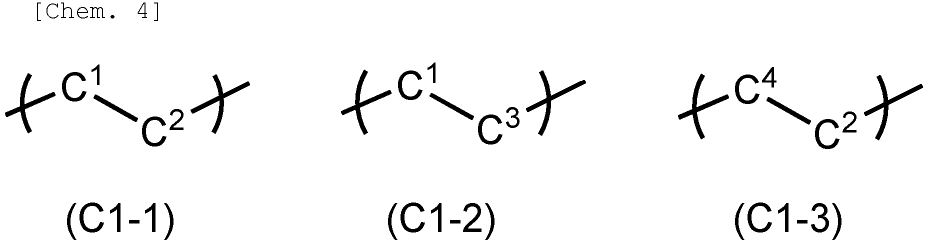

In the formula, C¹ represents a group derived from an aromatic compound containing a nitrogen atom, C² represents a group containing a tertiary carbon atom or a quaternary carbon atom having at least one selected from a group consisting of a secondary carbon atom, a quaternary carbon atom, and an aromatic ring in a side chain, or represents a methylene group, C³ represents a group derived from an aliphatic polycyclic compound, and C⁴ represents a group derived from phenol, a group derived from bisphenol, a group derived from naphthol, a group derived from biphenyl, or a group derived from biphenol.

That is, the Novolac resin contains, for example, one or more types of the following structural units.
· Structural unit having a bond between a group derived from an aromatic compound containing a nitrogen atom and a group containing a tertiary carbon atom or a quaternary carbon atom or a methylene group having at least one selected from the group consisting of a secondary carbon atom, a quaternary carbon atom, and an aromatic ring in a side chain (Formula (C1-1))
· Structural unit having a bond between a group derived from an aromatic compound containing a nitrogen atom and a group derived from aliphatic polycyclic compound (Formula (C1-2))
· A structural unit having a bond between a group derived from phenol, a group derived from bisphenol, a group derived from naphthol, a group derived from biphenyl, or a group derived from biphenol, and a group containing a tertiary carbon atom or a quaternary carbon atom or a methylene group having at least one selected from the group consisting of a quaternary carbon atom and an aromatic ring in the side chain ((Formula (C1-3))

In a preferred aspect, the Novolac resin contains any one or both of a structural unit (formula (C1-1)) having a bond between a group derived from an aromatic compound containing a nitrogen atom and a group containing a tertiary carbon atom or a quaternary carbon atom or a methylene group having at least one selected from the group consisting of a secondary carbon atom, a quaternary carbon atom, and an aromatic ring in a side chain, and a structural unit (formula (C1-2)) having a bond between a group derived from an aromatic compound containing a nitrogen atom and a group derived from an aliphatic polycyclic compound.

The group derived from the aromatic compound containing the nitrogen atom of C¹ can be, for example, a group derived from carbazole, a group derived from N-phenyl-1-naphthylamine, a group derived from N-phenyl-2-naphthylamine, or the like, but is not limited thereto.

The group containing a tertiary carbon atom or a quaternary carbon atom or the methylene group having at least one selected from the group consisting of a secondary carbon atom, a quaternary carbon atom, and an aromatic ring in the side chain of C² can be, for example, a group derived from 1-naphthaldehyde, a group derived from 1-pyrenecarboxaldehyde, a group derived from 4-(trifluoromethyl)benzaldehyde, a group derived from 2-ethylhexylaldehyde, a group derived from acetaldehyde, or the like, but is not limited thereto.

The group derived from the aliphatic polycyclic compound of C³ can be, but is not limited to, a group derived from dicyclopentadiene.

C⁴ is a group derived from phenol, a group derived from bisphenol, a group derived from naphthol, a group derived from biphenyl, or a group derived from biphenol.

In a preferred aspect, the Novolac resin contains, for example, a structural unit represented by the following Formula (C1-1-1) as the structural unit represented by Formula (C1-1).

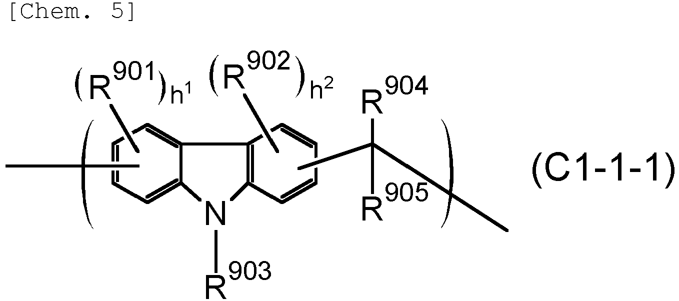

In Formula (C1-1-1), R⁹⁰¹ and R⁹⁰² represent a substituent substituted with a ring, and each independently represent a halogen atom, a nitro group, a cyano group, an amino group, a hydroxy group, a carboxy group, an optionally substituted alkyl group, an optionally substituted alkenyl group, or an optionally substituted aryl group.

R⁹⁰³ represents a hydrogen atom, an optionally substituted alkyl group, an optionally substituted alkenyl group, or an optionally substituted aryl group.

R⁹⁰⁴ represents a hydrogen atom, an optionally substituted aryl group, or an optionally substituted heteroaryl group.

R⁹⁰⁵ represents an optionally substituted alkyl group, an optionally substituted aryl group, or an optionally substituted heteroaryl group.

The group of R⁹⁰⁴ and the group of R⁹⁰⁵ may be bonded to each other to form a divalent group.

Examples of the substituent of the alkyl group and the alkenyl group include a halogen atom, a nitro group, a cyano group, an amino group, a hydroxy group, a carboxy group, an aryl group, and a heteroaryl group.

Examples of the substituent of the aryl group and the heteroaryl group include a halogen atom, a nitro group, a cyano group, an amino group, a hydroxy group, a carboxy group, an alkyl group, and an alkenyl group.

h¹ and h² each independently represent an integer of 0 to 3.

In the present invention, the "aryl group" means an aryl group (aromatic hydrocarbon group) having no heteroatom.

The number of carbon atoms of the optionally substituted alkyl group and the optionally substituted alkenyl group is usually 40 or less, and from the viewpoint of solubility, the number of carbon atoms is preferably 30 or less, and more preferably 20 or less.

The number of carbon atoms of the optionally substituted aryl group and heteroaryl group is usually 40 or less, and from the viewpoint of solubility, preferably 30 or less, and more preferably 20 or less.

Examples of the halogen atom include fluorine atom, chlorine atom, bromine atom, and iodine atom.

Specific examples of the optionally substituted alkyl group include a methyl group, an ethyl group, an n-propyl group, an i-propyl group, an n-butyl group, an i-butyl group, an s-butyl group, a t-butyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, an n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, a 1-ethyl-2-methyl-n-propyl group, and a 2-ethylhexyl group, but are not limited thereto.

Specific examples of the optionally substituted alkenyl group include an ethenyl group, a 1-propenyl group, a 2-propenyl group, a 1-methyl-1-ethenyl group, a 1-butenyl group, a 2-butenyl group, a 3-butenyl group, a 2-methyl-1-propenyl group, a 2-methyl-2-propenyl group, a 1-ethylethenyl group, a 1-methyl-1-propenyl group, a 1-methyl-2-propenyl group, a 1-pentenyl group, a 2-pentenyl group, a 3-pentenyl group, a 4-pentenyl group, a 1-n-propylethenyl group, a 1-methyl-1-butenyl group, a 1-methyl-2-butenyl group, a 1-methyl-3-butenyl group, a 2-ethyl-2-propenyl group, 2-methyl-1-butenyl group, 2-methyl-2-butenyl group, 2-methyl-3-butenyl group, 3-methyl-1-butenyl group, 3-methyl-2-butenyl group, 3-methyl-3-butenyl group, 1,1-dimethyl-2-propenyl group, 1-i-propylethenyl group, 1,2-dimethyl-2-propenyl group, 1,2-dimethyl-2-propenyl group, 1-cyclopentenyl group, 2-cyclopentenyl group, 3-cyclopentenyl group, 1-hexenyl group, 2-hexenyl group, 3-hexenyl group, 4-hexenyl group, 5-hexenyl group, 1-methyl-1-pentenyl group, 1-methyl-2-pentenyl group, 1-methyl-3-pentenyl group, 1-methyl-4-pentenyl group, 1-n-butylethenyl group, 2-methyl-1-pentenyl group, 2-methyl-2-pentenyl group, 2-methyl-3-pentenyl group, 2-methyl-4-pentenyl group, 2-n-propyl-2-propenyl group, 3-methyl-1-pentenyl group, 3-methyl-2-pentenyl group, 3-methyl-3-pentenyl group, 3-methyl-4-pentenyl group, 3-ethyl-3-butenyl group, 4-methyl-1-pentenyl group, 4-methyl-2-pentenyl group, 4-methyl-3-pentenyl group, 4-methyl-4 pentenyl group, 1,1-dimethyl-2-butenyl group, 1,1-dimethyl-3-butenyl group, 1,2-dimethyl-1-butenyl group, 1,2-dimethyl-2-butenyl group, 1,2-dimethyl-3-butenyl group, 1-methyl-2-ethyl-2-propenyl group, 1-s-butylethenyl group, 1,3-dimethyl-1-butenyl group, 1,3-dimethyl-2-butenyl group, 1,3-dimethyl-3-butenyl group, 1-i-butylethenyl group, 2,2-dimethyl-3-butenyl group, 2,3-dimethyl-1-butenyl group, 2,3-dimethyl-2-butenyl group, 2,3-dimethyl-2-butenyl group, 2,3-dimethyl-3-butenyl group, 2-i-propyl-2-propenyl group, 3,3-dimethyl-1-butenyl group, 1-ethyl-1-butenyl group, 1-ethyl-2-butenyl group, 1-ethyl-3-butenyl group, 1-n-propyl-1-propenyl group, 1-n-propyl-2-propenyl group, 2-ethyl-1-butenyl group, 2-ethyl-2-butenyl group, 2-ethyl-3-butenyl group, 1,1,2-trimethyl-2-propenyl group, 1-tertiary butylethenyl group, 1-methyl-1-ethyl-2-propenyl group, 1-ethyl-2-methyl-1-propenyl group, 1-ethyl-2-methyl-2-propenyl group, 1-i-propyl-2-propenyl group, 1-i-propyl-1-propenyl group, 1-i-propyl-2-propenyl group, 1-methyl-2-cyclopentenyl group, 1-methyl-3-cyclopentenyl group, 2-methyl-1-cyclopentenyl group, 2-methyl-2-cyclopentenyl group, a 2-methyl-3-cyclopentenyl group, a 2-methyl-4-cyclopentenyl group, a 2-methyl-5-cyclopentenyl group, a 2-methylene-cyclopentyl group, a 3-methyl-1-cyclopentenyl group, a 3-methyl-2-cyclopentenyl group, a 3-methyl-3-cyclopentenyl group, a 3-methyl-4-cyclopentenyl group, a 3-methyl-5-cyclopentenyl group, a 3-methylene-cyclopentyl group, a 1-cyclohexenyl group, a 2-cyclohexenyl group, and a 3-cyclohexenyl group, but are not limited thereto.

Specific examples of the optionally substituted aryl group include a phenyl group, a 2-methylphenyl group, a 3-methylphenyl group, a 4-methylphenyl group, a 2-chlorophenyl group, a 3-chlorophenyl group, a 4-chlorophenyl group, a 2-fluorophenyl group, a 3-fluorophenyl group, a 4-fluorophenyl group, a 4-methoxyphenyl group, a 4-ethoxyphenyl group, a 4-nitrophenyl group, a 4-cyanophenyl group, a 1-naphthyl group, a 2-naphthyl group, a biphenyl-4-yl group, a biphenyl-3-yl group, a biphenyl-2-yl group, a 1-anthryl group, a 2-anthryl group, a 9-anthryl group, a 1-phenanthryl group, a 2-phenanthryl group, a 3-phenanthryl group, a 4-phenanthryl group, and a 9-phenanthryl group, but are not limited thereto.

Specific examples of the optionally substituted heteroaryl group include a 2-thienyl group, a 3-thienyl group, a 2-furanyl group, a 3-furanyl group, a 2-oxazolyl group, a 4-oxazolyl group, a 5-oxazolyl group, a 3-isoxazolyl group, a 4-isoxazolyl group, a 5-isoxazolyl group, a 2-thiazolyl group, a 4-thiazolyl group, a 5-thiazolyl group, a 3-isothiazolyl group, a 4-isothiazolyl group, and a 5-isothiazolyl group, but are not limited thereto.

Hereinafter, specific examples of the structural unit represented by Formula (C1-1-1) will be given, but the structural unit is not limited thereto.

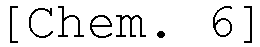

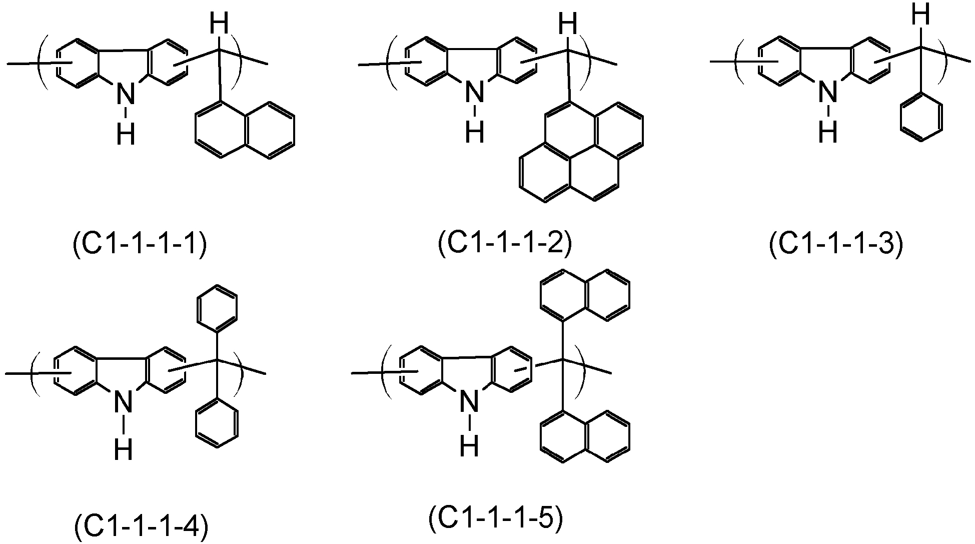

In a preferred aspect, the Novolac resin contains, for example, a structural unit represented by the following Formula (C1-1-2) as the structural unit represented by Formula (C1-1).

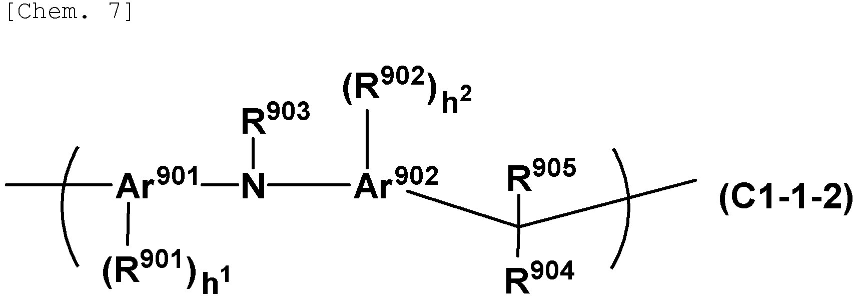

In Formula (C1-1-2), Ar⁹⁰¹ and Ar⁹⁰² each independently represent an aromatic ring, and R⁹⁰¹ to R⁹⁰⁵ and h¹ and h² represent the same meaning as described above.

Examples of the aromatic ring include a benzene ring and a naphthalene ring.

Hereinafter, specific examples of the structural unit represented by Formula (C1-1-2) will be given, but the structural unit is not limited thereto.

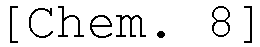

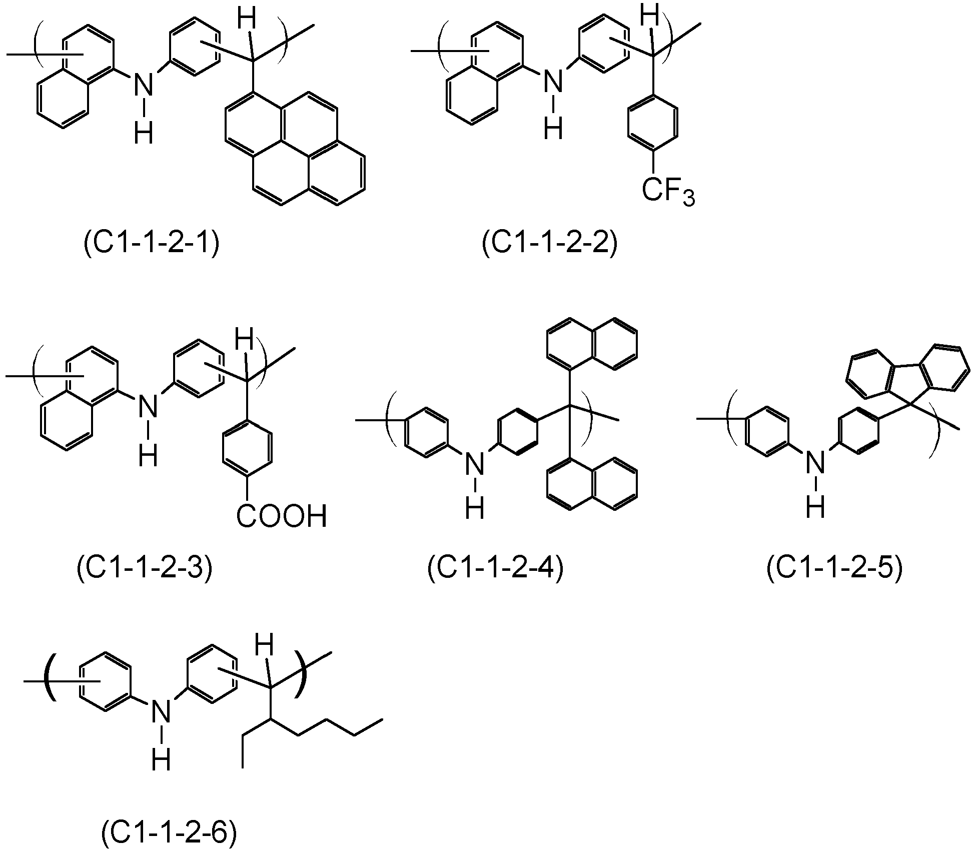

In a preferred aspect, the Novolac resin contains, for example, a structural unit represented by the following Formula (C1-2-1) or (C1-2-2) as the structural unit represented by Formula (C1-2).

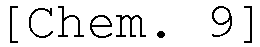

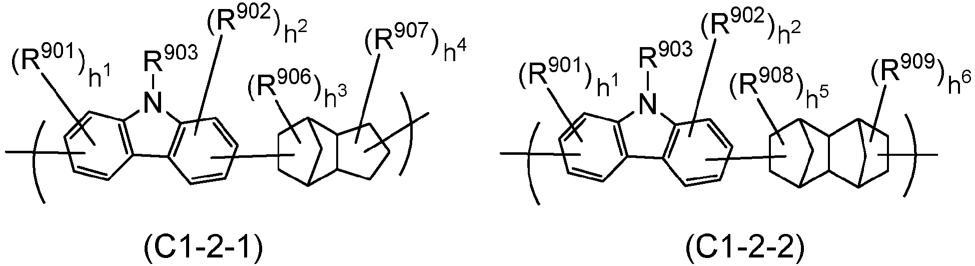

In the above formula, R⁹⁰⁶ to R⁹⁰⁹ are substituents bonded to a ring, and each independently represent a halogen atom, a nitro group, a cyano group, an amino group, a hydroxy group, a carboxy group, an optionally substituted alkyl group, an optionally substituted alkenyl group, or an optionally substituted aryl group. Specific examples and suitable numbers of carbon atoms of the halogen atom, the optionally substituted alkyl group, the optionally substituted alkenyl group, and the optionally substituted aryl group are the same as those described above, h³ to h⁶ each independently represent an integer of 0 to 3, and R⁹⁰¹ to R⁹⁰³ and h¹ and h² each represent the same meaning as described above.

Specific examples of the structural units represented by Formulas (C1-2-1) and (C1-2-2) will be given below, but the structural units are not limited thereto.

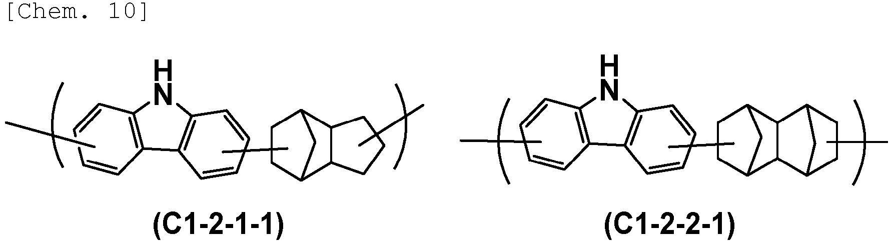

Hereinafter, specific examples of the structural unit represented by Formula (C1-3) will be given, but the structural unit is not limited thereto.

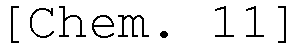

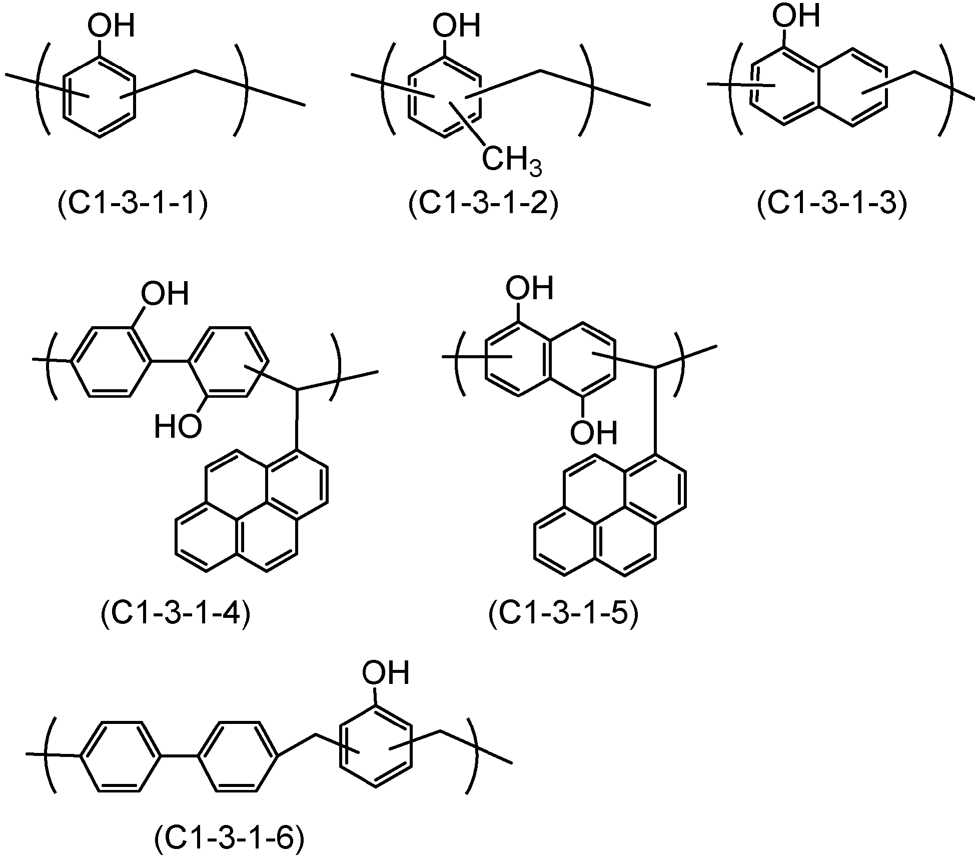

As described above, the Novolac resin is, for example, a resin obtained by condensation reaction of at least one of a phenolic compound, a carbazole compound, and an aromatic amine compound with at least one of an aldehyde compound, a ketone compound, and a divinyl compound under an acid catalyst.

In this condensation reaction, for example, an aldehyde compound or a ketone compound is usually used in a ratio of 0.1 to 10 equivalents to 1 equivalent of a benzene ring constituting a ring of a carbazole compound.

In the condensation reaction, an acid catalyst is usually used.

Examples of the acid catalyst include mineral acids such as sulfuric acid, phosphoric acid, and perchloric acid, organic sulfonic acids such as p-toluenesulfonic acid and p-toluenesulfonic acid monohydrate, and carboxylic acids such as formic acid and oxalic acid, but are not limited thereto.

The amount of the acid catalyst is appropriately determined depending on the type of the acid to be used and the like, and thus cannot be generally defined, but is usually appropriately determined from the range of 0.001 to 10,000 parts by mass with respect to 100 parts by mass of the carbazole compound.

When either the raw material compound or the acid catalyst to be used is a liquid, the condensation reaction can be performed without using a solvent in some cases, but is usually performed using a solvent.

Such a solvent is not particularly limited as long as the reaction is not inhibited, but typically includes an ether compound, an ether ester compound, and the like.

Examples of the ether compound include cyclic ether compounds such as tetrahydrofuran and dioxane.

Examples of the ether ester compound include methyl cellosolve acetate, ethyl cellosolve acetate, butyl cellosolve acetate, propylene glycol monomethyl ether acetate (PGMEA), propylene glycol monoethyl ether acetate, propylene glycol monopropyl ether acetate, propylene glycol monomethyl ether propionate, propylene glycol monoethyl ether propionate, and propylene glycol monopropyl ether propionate.

The reaction temperature is usually appropriately determined from the range of 40°C to 200°C, and the reaction time cannot be generally specified because the reaction time varies depending on the reaction temperature, but is usually appropriately determined from the range of 30 minutes to 50 hours.

After completion of the reaction, if necessary, purification and isolation are performed according to a conventional method, and the obtained Novolac resin is used for preparation of a release agent composition.

Those skilled in the art can determine the production conditions of the Novolac resin without an excessive burden based on the above description and the common general technical knowledge, and therefore can produce the Novolac resin.

The weight average molecular weight of the Novolac resin is usually 500 to 200,000, and is preferably 100,000 or less, more preferably 50,000 or less, still more preferably 10,000 or less, still more preferably 5,000 or less, and still more preferably 3,000 or less from the viewpoint of securing solubility in a solvent and the like, and is preferably 600 or more, more preferably 700 or more, still more preferably 800 or more, still more preferably 900 or more, and still more preferably 1,000 or more from the viewpoint of improving the strength of the film and the like.

In the present invention, the weight average molecular weight, the number average molecular weight, and the dispersibility of the Novolac resin can be measured, for example, using a GPC apparatus (EcoSEC, HLC-8320GPC manufactured by Tosoh Corporation) and a GPC column (TSKgel SuperMultiporeHZ-N and TSKgel SuperMultiporeHZ-H manufactured by Tosoh Corporation), at a column temperature of 40°C, using tetrahydrofuran as an eluent (elution solvent), at a flow rate of 0.35 mL/min, and using polystyrene (manufactured by Sigma-Aldrich) as a standard sample.

The lower limit value of the content of the Novolac resin in the release agent composition is not particularly limited. The content of the Novolac resin in the release agent composition is preferably 10% by mass or more, more preferably 20% by mass or more, and particularly preferably 25% by mass or more, with respect to the total of the Novolac resin and the (meth)acrylic acid ester-based polymer.

The upper limit value of the content of the Novolac resin in the release agent composition is not particularly limited. The content of the Novolac resin in the release agent composition is preferably 65% by mass or less, more preferably 60% by mass or less, and particularly preferably 55% by mass or less with respect to the total of the Novolac resin and the (meth)acrylic acid ester-based polymer.

### <(Meth)acrylic Acid Ester-based Polymer>

The (meth)acrylic acid ester-based polymer is a polymer containing a repeating unit derived from a (meth)acrylic acid alkyl ester.

The (meth)acrylic acid alkyl ester is a generic term for acrylic acid alkyl ester and methacrylic acid alkyl ester.

The number of carbon atoms in the (meth)acrylic acid alkyl ester is not particularly limited, but is preferably 4 to 20, and more preferably 4 to 10.

Examples of the alkyl acrylate include methyl acrylate, ethyl acrylate, n-propyl acrylate, n-butyl acrylate, isobutyl acrylate, n-pentyl acrylate, n-hexyl acrylate, n-octyl acrylate, isooctyl acrylate, 2-ethylhexyl acrylate, dodecyl acrylate, and decyl acrylate.

Examples of the alkyl methacrylate include methyl methacrylate, ethyl methacrylate, n-propyl methacrylate, n-butyl methacrylate, isobutyl methacrylate, n-pentyl methacrylate, n-hexyl methacrylate, n-octyl methacrylate, isooctyl methacrylate, 2-ethylhexyl methacrylate, dodecyl methacrylate, and decyl methacrylate.

These can be used alone or in combination of two or more thereof.

Among them, methyl methacrylate is preferable.

The (meth)acrylic acid ester-based polymer may have a repeating unit other than the repeating unit derived from the (meth)acrylic acid alkyl ester. Examples of the monomer constituting such a repeating unit include polymerizable unsaturated group-containing monomers other than the (meth)acrylic acid ester-based polymer. Examples of such a monomer include a carboxyl group-containing monomer, a hydroxy group-containing monomer, a (meth)acrylamide-based monomer, and a styrene-based monomer.

The (meth)acrylic acid ester-based polymer may be a homopolymer or a copolymer.

The (meth)acrylic acid ester-based polymer preferably contains polymethyl methacrylate (polymethyl methacrylic acid).

The molar ratio of the repeating unit derived from the (meth)acrylic acid alkyl ester in all the repeating units of the (meth)acrylic acid ester-based polymer is not particularly limited, but is preferably 50% by mol to 100% by mol, more preferably 75% by mol to 100% by mol, and particularly preferably 90% by mol to 100% by mol.

The Tg of the (meth)acrylic acid ester-based polymer is not particularly limited, but is preferably 30°C to 150°C, and more preferably 40°C to 120°C°C.

The Tg of the (meth)acrylic acid ester-based polymer can be determined, for example, by differential scanning calorimetry.

The molecular weight of the (meth)acrylic acid ester-based polymer is not particularly limited, but the weight average molecular weight of the (meth)acrylic acid ester-based polymer is preferably 10,000 to 200,000, and more preferably 30,000 to 100,000.

The molecular weight of the (meth)acrylic acid ester-based polymer can be determined, for example, by gel permeation chromatography (GPC) using polystyrene as a standard sample.

The lower limit value of the content of the (meth)acrylic acid ester-based polymer in the release agent composition is not particularly limited. The content of the (meth)acrylic acid ester-based polymer in the release agent composition is preferably 35% by mass or more, more preferably 40% by mass or more, and particularly preferably 45% by mass or more with respect to the total of the Novolac resin and the (meth)acrylic acid ester-based polymer.

The upper limit value of the content of the (meth)acrylic acid ester-based polymer in the release agent composition is not particularly limited. The content of the (meth)acrylic acid ester-based polymer in the release agent composition is preferably 90% by mass or less, more preferably 80% by mass or less, and particularly preferably 75% by mass or less with respect to the total of the Novolac resin and the (meth)acrylic acid ester-based polymer.

The total content of the Novolac resin and the (meth)acrylic acid ester-based polymer in the release agent composition is not particularly limited, but is preferably 50% by mass to 100% by mass, more preferably 70% by mass to 100% by mass, and particularly preferably 90% by mass to 100% by mass with respect to the film constituent. In the present invention, the film constituent means a component other than the solvent contained in the composition.

### <Crosslinking Agent>

The release agent composition may include a crosslinking agent.

The crosslinking agent may cause a crosslinking reaction by self-condensation, but when crosslinkable substituents are present in the Novolac resin, the crosslinking agent can cause a crosslinking reaction with these crosslinkable substituents.

Specific examples of the crosslinking agent are not particularly limited, but typically include phenol-based crosslinking agents, melamine-based crosslinking agents, urea-based crosslinking agents, thiourea-based crosslinking agents, and the like, each of which has a crosslinking-forming group in the molecule, such as an alkoxymethyl group (for example, a hydroxymethyl group, a methoxymethyl group, or a butoxymethyl group), and these may be low molecular weight compounds or high molecular weight compounds.

The crosslinking agent contained in the release agent composition usually has two or more crosslinking-forming groups, but from the viewpoint of realizing more suitable curing with good reproducibility, the number of crosslinking groups contained in the compound as a crosslinking agent is preferably 2 to 10, and more preferably 2 to 6.

The crosslinking agent contained in the release agent composition preferably has an aromatic ring (for example, a benzene ring or a naphthalene ring) in the molecule from the viewpoint of achieving higher heat resistance, and typical examples of such a crosslinking agent include, but are not limited to, phenol-based crosslinking agents.

The phenol-based crosslinking agent having a crosslinking-forming group is a compound having a crosslinking-forming group bonded to an aromatic ring and having at least one of a phenolic hydroxy group and an alkoxy group derived from a phenolic hydroxy group, and examples of the alkoxy group derived from such a phenolic hydroxy group include a methoxy group and a butoxy group, but are not limited thereto.

Each of the aromatic ring to which the crosslinking-forming group is bonded and the aromatic ring to which the phenolic hydroxy group and/or the alkoxy group derived from a phenolic hydroxy group is bonded is not limited to a noncondensed ring type aromatic ring such as a benzene ring, and may be a condensed ring type aromatic ring such as a naphthalene ring or anthracene.

When a plurality of aromatic rings are present in the molecule of the phenol-based crosslinking agent, the crosslinking-forming group and the alkoxy group derived from the phenolic hydroxy group and the phenolic hydroxy group may be bonded to the same aromatic ring in the molecule or may be bonded to different aromatic rings.

The aromatic ring to which the crosslinking-forming group, the phenolic hydroxy group, and the alkoxy group derived from the phenolic hydroxy group are bonded may be further substituted with an alkyl group such as a methyl group, an ethyl group, or a butyl group, a hydrocarbon group such as an aryl group (for example, a phenyl group), a halogen atom such as a fluorine atom, or the like.

For example, specific examples of the phenol-based crosslinking agent having a crosslinking-forming group include compounds represented by any of Formulas (L1) to (L4).

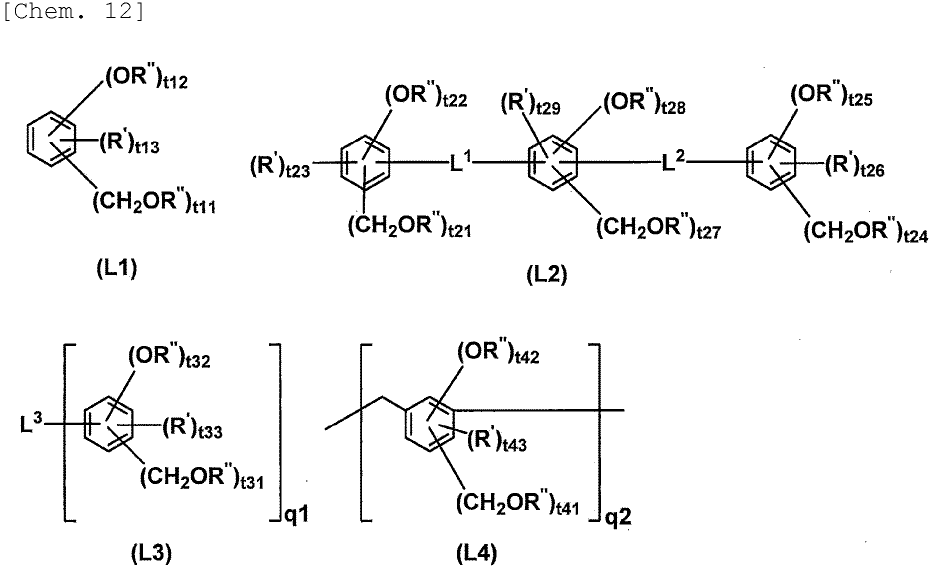

Each R' independently represents a fluorine atom, an aryl group, or an alkyl group, each R" independently represents a hydrogen atom or an alkyl group, L¹ and L² each independently represent a single bond, a methylene group, or a propane-2,2-diyl group, L³ is determined according to q1 and represents a single bond, a methylene group, a propane-2,2-diyl group, a methantriyl group, or an ethane-1,1,1-triyl group, t11, t12, and t13 are integers satisfying 2 ≤ t11 ≤ 5, 1 ≤ t12 ≤ 4, 0 ≤ t13 ≤ 3, and t11 + t12 + t13 ≤ 6, t21, t22, and t23 are integers satisfying 2 ≤ t21 ≤ 4, 1 ≤ t22 ≤ 3, 0 ≤ t23 ≤ 2, and t21 + t22 + t23 ≤ 5, t24, t25, and t26 are integers satisfying 2 ≤ t24 ≤ 4, 1 ≤ t25 ≤ 3, 0 ≤ t26 ≤ 2, and t24 + t25 + t26 ≤ 5, t27, t28, and t29 are integers satisfying 0 ≤ t27 ≤ 4, 0 ≤ t28 ≤ 4, 0 ≤ t29 ≤ 4, and t27 + t28 + t29 ≤ 4, t31, t32, and t33 are integers satisfying 2 ≤ t31 ≤ 4, 1 ≤ t32 ≤ 3, 0 ≤ t33 ≤ 2, and t31 + t32 + t33 ≤ 5, t41, t42, and t43 are integers satisfying 2 ≤ t41 ≤ 3, 1 ≤ t42 ≤ 2, 0 ≤ t43 ≤ 1, and t41 + t42 + t43 ≤ 4, q1 is 2 or 3, q2 represents the number of repetitions and is an integer of 0 or more, and specific examples of the aryl group and the alkyl group include those same as the following specific examples, but the aryl group is preferably a phenyl group, and the alkyl group is preferably a methyl group or a t-butyl group.

Hereinafter, specific examples of the compounds represented by Formulas (L1) to (L4) will be given, but the compounds are not limited thereto. These compounds may be synthesized by a known method, and can also be obtained, for example, as a product of Asahi Organic Chemical Industry Co., Ltd. or Honshu Chemical Industry Co., Ltd.

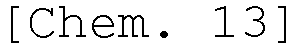

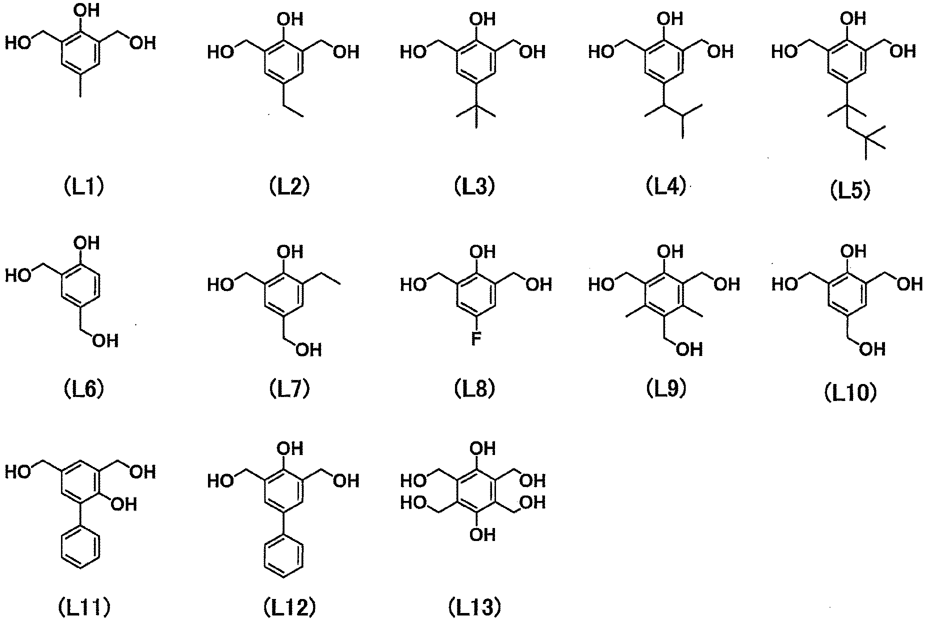

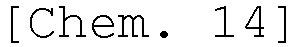

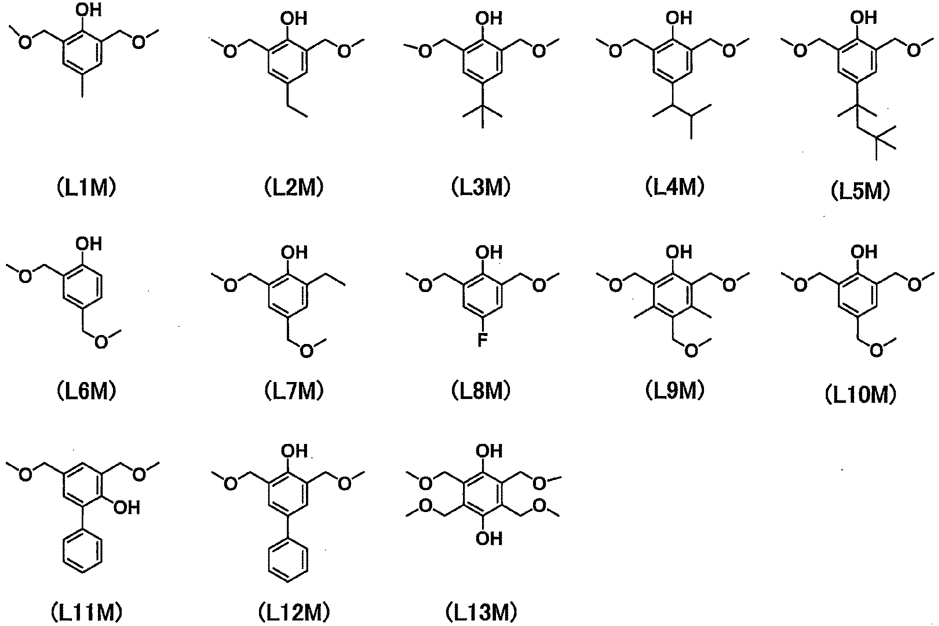

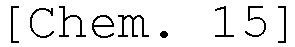

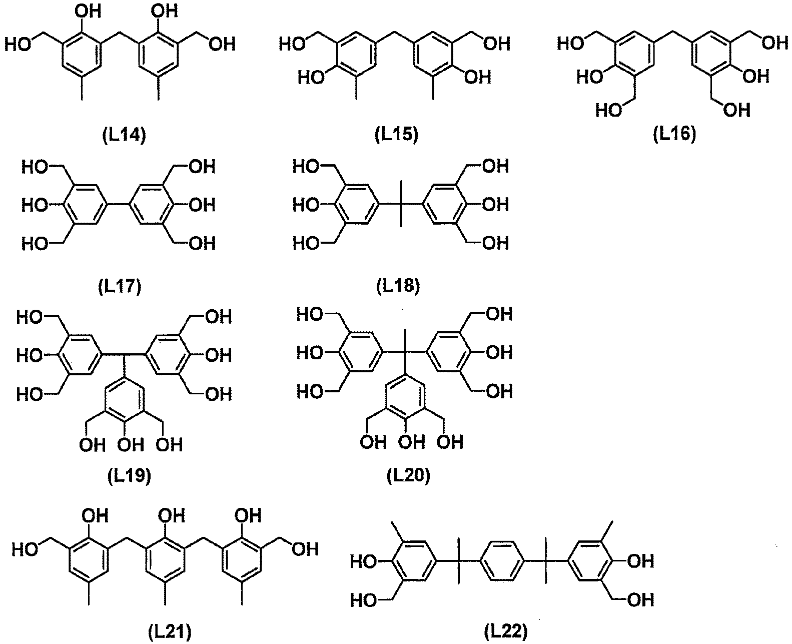

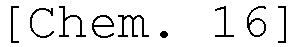

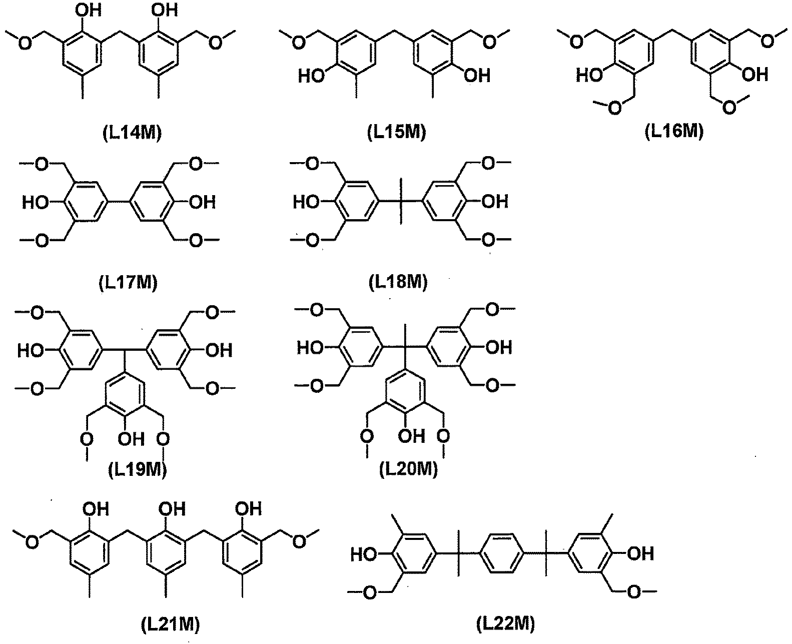

The melamine-based crosslinking agent having a crosslinking-forming group is a melamine derivative, a 2,4-diamino-1,3,5-triazine derivative, or a 2-amino-1,3,5-triazine derivative in which at least one of hydrogen atoms of an amino group bonded to a triazine ring thereof is substituted with a crosslinking-forming group, and the triazine ring may further have a substituent such as an aryl group such as a phenyl group.

Specific examples of the melamine-based crosslinking agent having a crosslinking-forming group include mono-, bis-, tris-, tetrakis-, pentakis- or hexakisalkoxymethylmelamines such as N,N,N',N',N",N"-hexakis(methoxymethyl)melamine and N,N,N',N',N",N"-hexakis(butoxymethyl)melamine; and mono-, bis-, tris- or tetrakisalkoxymethylbenzoguanamines such as N,N,N',N'-tetrakis(methoxymethyl)benzoguanamine and N,N,N',N'-tetrakis(butoxymethyl)benzoguanamine, but are not limited thereto.

The urea-based crosslinking agent having a crosslinking-forming group is a derivative of a urea bond-containing compound, and has a structure in which at least one of hydrogen atoms of an NH group constituting a urea bond is substituted with a crosslinking-forming group.

Specific examples of the urea-based crosslinking agent having a crosslinking-forming group include mono-, bis-, tris-, or tetrakisalkoxymethylglycolurils such as 1,3,4,6-tetrakis(methoxymethyl)glycoluril and 1,3,4,6-tetrakis(butoxymethyl)glycoluril; and mono-, bis-, tris-, or tetrakisalkoxymethylureas such as 1,3-bis(methoxymethyl)urea and 1,1,3,3-tetrakismethoxymethylurea, but are not limited thereto.

The thiourea-based crosslinking agent having a crosslinking-forming group is a derivative of a thiourea bond-containing compound, and has a structure in which at least one of hydrogen atoms of an NH group constituting a thiourea bond is substituted with a crosslinking-forming group.

Specific examples of the thiourea-based crosslinking agent having a crosslinking-forming group include mono-, bis-, tris-, or tetrakisalkoxymethylthioureas such as 1,3-bis(methoxymethyl)thiourea and 1,1,3,3-tetrakismethoxymethylthiourea, but are not limited thereto.

The amount of the crosslinking agent contained in the release agent composition varies depending on the coating method to be employed, the desired film thickness, and the like, and thus cannot be generally specified. However, the amount is usually 0.01 to 50% by mass with respect to the total of the Novolac resin and the (meth)acrylic acid ester-based polymer, and from the viewpoint of realizing suitable curing and obtaining a laminate in which a semiconductor substrate or an electronic device layer and a support substrate can be satisfactorily separated from each other with good reproducibility, is preferably 0.1% by mass or more, more preferably 1% by mass or more, still more preferably 3% by mass or more, and still more preferably 50 by mass or more, and is preferably 45% by mass or less, more preferably 40% by mass or less, still more preferably 35% by mass or less, and still more preferably 30% by mass or less.

### <Acid Generating Agent and Acid>

For the purpose of, for example, promoting the crosslinking reaction, the release agent composition may contain an acid generating agent or an acid.

Examples of the acid generating agent include a thermal acid generating agent and a photoacid generating agent.

The thermal acid generating agent is not particularly limited as long as an acid is generated by heat, and specific examples thereof include 2,4,4,6-tetrabromocyclohexadienone, benzoin tosylate, 2-nitrobenzyl tosylate, K-PURE [registered trademark] CXC-1612, CXC-1614, TAG-2172, TAG-2179, TAG-2678, TAG2689, and TAG2700 (manufactured by King Industries, Inc.), and SI-45, SI-60, SI-80, SI-100, SI-110, and SI-150 (manufactured by Sanshin Chemical Industry Co., Ltd.), and other organic sulfonic acid alkyl esters, but are not limited thereto.

Examples of the photoacid generating agent include an onium salt compound, a sulfonimide compound, and a disulfonyldiazomethane compound.

Specific examples of the onium salt compound include iodonium salt compounds such as diphenyliodonium hexafluorophosphate, diphenyliodonium trifluoromethanesulfonate, diphenyliodonium nonafluoronormal butanesulfonate, diphenyliodonium perfluoronormal octanesulfonate, diphenyliodonium camphor sulfonate, bis(4-tert-butylphenyl)iodonium camphor sulfonate, and bis(4-tert-butylphenyl)iodonium trifluoromethanesulfonate; and sulfonium salt compounds such as triphenylsulfonium nitrate, triphenylsulfonium hexafluoroantimonate, triphenylsulfonium nonafluoro-normal butanesulfonate, triphenylsulfonium camphorsulfonate, and triphenylsulfonium trifluoromethanesulfonate, but are not limited thereto.

Specific examples of the sulfonimide compound include N-(trifluoromethanesulfonyloxy)succinimide, N-(nonafluoronormalbutanesulfonyloxy)succinimide, N-(camphorsulfonyloxy)succinimide, and N-(trifluoromethanesulfonyloxy)naphthalimide, but are not limited thereto.

Specific examples of the disulfonyl diazomethane compound include bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, and methylsulfonyl-p-toluenesulfonyl diazomethane, but are not limited thereto.

Specific examples of the acid include arylsulfonic acids and pyridinium salts such as p-toluenesulfonic acid, pyridinium p-toluenesulfonate(pyridinium paratoluenesulfonate), pyridinium trifluoromethanesulfonate, pyridinium phenolsulfonic acid, 5-sulfosalicylic acid, 4-phenolsulfonic acid, 4-chlorobenzenesulfonic acid, benzenedisulfonic acid, and 1-naphthalenesulfonic acid, and salts thereof; arylcarboxylic acids such as salicylic acid, benzoic acid, hydroxybenzoic acid, and naphthalenecarboxylic acid, and salts thereof; linear or cyclic alkylsulfonic acids such as trifluoromethanesulfonic acid and camphorsulfonic acid, and salts thereof; and linear or cyclic alkylcarboxylic acids such as citric acid, and salts thereof, but are not limited thereto.

The amounts of the acid generating agent and the acid contained in the release agent composition cannot be generally specified because the amounts vary depending on the type of the crosslinking agent to be used together, the heating temperature at the time of forming the film, and the like, but are usually 0.01 to 5% by mass with respect to the film constituent.

### <Surfactant>

The release agent composition may contain a surfactant for the purpose of, for example, adjusting the liquid physical properties of the composition itself or the film physical properties of the obtained film, or preparing a highly uniform release agent composition with high reproducibility.

Examples of the surfactant include nonionic surfactants such as polyoxyethylene alkyl ethers (for example, polyoxyethylene lauryl ether, polyoxyethylene stearyl ether, polyoxyethylene cetyl ether, and polyoxyethylene oleyl ether), polyoxyethylene alkyl allyl ethers (for example, polyoxyethylene octylphenol ether and polyoxyethylene nonylphenol ether), polyoxyethylene/polyoxypropylene block copolymers, sorbitan fatty acid esters (for example, sorbitan monolaurate, sorbitan monopalmitate, sorbitan monostearate, sorbitan monooleate, sorbitan trioleate, and sorbitan tristearate), and polyoxyethylene sorbitan fatty acid esters such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate, fluorine surfactants EFTOP EF301, EF303, and EF352 (manufactured by Tohkem Products Corporation, trade name), MEGAFACE F171, F173, R-30, and R-30N (manufactured by DIC Corporation, trade name), FLUORAD FC430 and FC431 (manufactured by Sumitomo 3M Ltd., trade name), ASAHIGUARD AG710, SURFLON S-382, SC101, SC102, SC103, SC104, SC105, and SC106 (manufactured by AGC Inc., trade name), and organosiloxane polymer KP341 (manufactured by Shin-Etsu Chemical Co., Ltd.).

Surfactants can be used alone or in combination of two or more thereof.

The amount of the surfactant is usually 2% by mass or less with respect to the film constituents of the release agent composition.

### <Solvent>

The release agent composition includes a solvent.

As the solvent, for example, a high-polarity solvent capable of satisfactorily dissolving film constituents such as the above-described Novolac resin, (meth)acrylic acid ester-based polymer, and crosslinking agent can be used, and if necessary, a low-polarity solvent may be used for the purpose of adjusting viscosity, surface tension, and the like. In the present invention, a low-polarity solvent having a relative permittivity of less than 7 at a frequency of 100 kHz is defined as a high-polarity solvent having a relative permittivity of 7 or more at a frequency of 100 kHz. The solvent can be used alone or in combination of two or more thereof.

Examples of the high-polarity solvent include amide-based solvents such as N,N-dimethylformamide, N,N-dimethylacetamide, N,N-dimethylisobutyramide, N-methylpyrrolidone, and 1,3-dimethyl-2 imidazolidinone; ketone-based solvent such as ethyl methyl ketone, isophorone, or cyclohexanone; cyano-based solvents such as acetonitrile and 3-methoxypropionitrile; polyhydric alcohol-based solvent such as ethylene glycol, diethylene glycol, triethylene glycol, dipropylene glycol, 1,3-butanediol, or 2,3-butanediol; monohydric alcohol-based solvents other than aliphatic alcohols such as propylene glycol monomethyl ether, diethylene glycol monomethyl ether, diethylene glycol monophenyl ether, triethylene glycol monomethyl ether, dipropylene glycol monomethyl ether, benzyl alcohol, 2-phenoxyethanol, 2-benzyloxyethanol, 3-phenoxybenzyl alcohol, and tetrahydrofurfuryl alcohol; and sulfoxide-based solvents such as dimethyl sulfoxide.

Examples of the low-polarity solvent include chlorine-based solvents such as chloroform and chlorobenzene; aromatic hydrocarbon-based solvents such as alkylbenzenes (for example, toluene, xylene, tetralin, cyclohexylbenzene, and decylbenzene); aliphatic alcohol-based solvents such as 1-octanol, 1-nonanol, and 1-decanol; ether-based solvent such as tetrahydrofuran, dioxane, anisole, 4-methoxytoluene, 3-phenoxytoluene, dibenzyl ether, diethylene glycol dimethyl ether, diethylene glycol butyl methyl ether, triethylene glycol dimethyl ether, or triethylene glycol butyl methyl ether; and ester-based solvents such as methyl benzoate, ethyl benzoate, butyl benzoate, isoamyl benzoate, bis(2-ethylhexyl)phthalate, dibutyl maleate, dibutyl oxalate, hexyl acetate, propylene glycol monomethyl ether acetate, diethylene glycol monoethyl ether acetate, and diethylene glycol monobutyl ether acetate.

The content of the solvent is appropriately determined in consideration of the viscosity of the desired composition, the coating method to be adopted, the thickness of the film to be prepared, and the like, but is 99% by mass or less with respect to the entire composition, preferably 70 to 99% by mass with respect to the entire composition, more preferably 75 to 90% by mass with respect to the entire composition, that is, the amount of the film constituent in that case is preferably 1 to 30% by mass with respect to the entire composition, and more preferably 10 to 25% by mass with respect to the entire composition.

The viscosity and surface tension of the release agent composition are appropriately adjusted by changing the type of the solvent to be used, the ratio thereof, the concentration of the film constituent, and the like in consideration of various factors such as the coating method to be used and the desired film thickness.

In an aspect of the present invention, the release agent composition contains a glycol-based solvent from the viewpoint of obtaining a highly uniform composition with good reproducibility, from the viewpoint of obtaining a highly storage stable composition with good reproducibility, from the viewpoint of obtaining a composition that provides a highly uniform film with good reproducibility, and the like. The "glycol-based solvent" as used herein is a generic term for glycols, glycol monoethers, glycol diethers, glycol monoesters, glycol diesters, and glycol ester ethers.

An example of a preferred glycol-based solvent is represented by Formula (G).

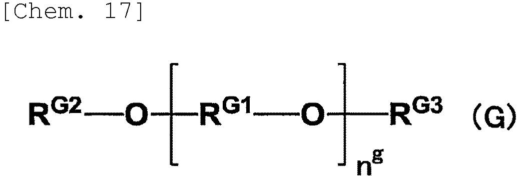

In Formula (G), R^{G1} each independently represents a linear or branched alkylene group having 2 to 4 carbon atoms, R^{G2} and R^{G3} each independently represent a hydrogen atom, a linear or branched alkyl group having 1 to 8 carbon atoms, or an alkylacyl group in which the alkyl portion is a linear or branched alkyl group having 1 to 8 carbon atoms, and n^{g} is an integer of 1 to 6.

Specific examples of the linear or branched alkylene group having 2 to 4 carbon atoms include an ethylene group, a trimethylene group, a 1-methylethylene group, a tetramethylene group, a 2-methylpropane-1,3-diyl group, a pentamethylene group, and a hexamethylene group, but are not limited thereto.

Among them, a linear or branched alkylene group having 2 to 3 carbon atoms is preferable, and a linear or branched alkylene group having 3 carbon atoms is more preferable from the viewpoint of obtaining a highly uniform composition with good reproducibility, from the viewpoint of obtaining a highly storage stable composition with good reproducibility, from the viewpoint of obtaining a composition that provides a highly uniform film with good reproducibility, and the like.

Specific examples of the linear or branched alkyl group having 1 to 8 carbon atoms include a methyl group, an ethyl group, an n-propyl group, an i-propyl group, an n-butyl group, an i-butyl group, an s-butyl group, a tertiary butyl group, an n-pentyl group, a 1-methyl-n-butyl group, a **2-**methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, an n-hexyl, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group, but are not limited thereto.

Among them, a methyl group and an ethyl group are preferable, and a methyl group is more preferable from the viewpoint of obtaining a highly uniform composition with good reproducibility, from the viewpoint of obtaining a highly storage stable composition with good reproducibility, from the viewpoint of obtaining a composition that provides a highly uniform film with good reproducibility, and the like.

Specific examples of the linear or branched alkyl group having 1 to 8 carbon atoms in the alkylacyl group in which the alkyl portion is a linear or branched alkyl group having 1 to 8 carbon atoms include the same as the specific examples described above.

Among them, a methylcarbonyl group and an ethylcarbonyl group are preferable, and a methylcarbonyl group is more preferable from the viewpoint of obtaining a highly uniform composition with good reproducibility, from the viewpoint of obtaining a highly storage stable composition with good reproducibility, from the viewpoint of obtaining a composition that provides a highly uniform film with good reproducibility, and the like.

The n^{g} is preferably 4 or less, more preferably 3 or less, still more preferably 2 or less, and most preferably 1 from the viewpoint of obtaining a highly uniform composition with good reproducibility, from the viewpoint of obtaining a highly storage stable composition with good reproducibility, from the viewpoint of obtaining a composition that provides a highly uniform film with good reproducibility, and the like.

In Formula (G), preferably, at least one of R^{G2} and R^{G3} is a linear or branched alkyl group having 1 to 8 carbon atoms, more preferably, one of R^{G2} and R^{G3} is a linear or branched alkyl group having 1 to 8 carbon atoms, and the other is an alkylacyl group in which a hydrogen atom or an alkyl portion is a linear or branched alkyl group having 1 to 8 carbon atoms from the viewpoint of obtaining a highly uniform composition with good reproducibility, from the viewpoint of obtaining a highly storage stable composition with good reproducibility, from the viewpoint of obtaining a composition giving a highly uniform film with good reproducibility, and the like.

The content of the glycol-based solvent is preferably 50% by mass or more, more preferably 70% by mass or more, still more preferably 80% by mass or more, still more preferably 90% by mass or more, and still more preferably 95% by mass or more with respect to the solvent contained in the release agent composition from the viewpoint of obtaining a highly uniform composition with good reproducibility, from the viewpoint of obtaining a highly storage stable composition with good reproducibility, from the viewpoint of obtaining a composition that provides a highly uniform film with good reproducibility, and the like.

In the release agent composition, the film constituent is uniformly dispersed or dissolved in the solvent, and preferably dissolved from the viewpoint of obtaining a highly uniform composition with good reproducibility, from the viewpoint of obtaining a highly storage stable composition with good reproducibility, from the viewpoint of obtaining a composition that provides a highly uniform film with good reproducibility, and the like.

In the present invention, for the purpose of removing foreign substances, a solvent, a solution, or the like to be used may be filtered using a filter or the like during the production of the release agent composition or after mixing all the components.

### (Laminate)

The laminate according to the present invention includes a semiconductor substrate or an electronic device layer, a support substrate, and a release agent layer for photoirradiation release.

The laminate according to the present invention preferably further includes an adhesive layer, and includes a semiconductor substrate or an electronic device layer, a support substrate, a release agent layer for photoirradiation release, and an adhesive layer.

When the release agent layer according to the present invention is formed to have not only a releasing function of releasing the semiconductor substrate or the electronic device layer from the support substrate by photoirradiation but also an adhesion function of adhering the semiconductor substrate or the electronic device layer to the support substrate (that is, when the release agent layer is formed using a release agent composition containing a component that exhibits both functions), the laminate may be formed not in a two-layer structure of the release agent layer and the adhesive layer but in a one-layer structure of the release agent layer having adhesive performance.

The support substrate is light-transmissive.

The release agent layer for photoirradiation release is provided between the semiconductor substrate or the electronic device layer and the support substrate.

The laminate is used for releasing the semiconductor substrate or the electronic device layer from the support substrate after the release agent layer absorbs light emitted from the support substrate side.

The release agent layer for photoirradiation release is a layer formed from the release agent composition for photoirradiation release of the present invention described above.

The laminate of the present invention is used for temporary adhesion for processing a semiconductor substrate or an electronic device layer, and can be suitably used for processing such as thinning of the semiconductor substrate or the electronic device layer.

While the semiconductor substrate is subjected to processing such as thinning, the semiconductor substrate is supported by the support substrate. On the other hand, after the processing of the semiconductor substrate, the release agent layer is irradiated with light, and thereafter, the support substrate and the semiconductor substrate are separated from each other. Due to the Novolac resin contained in the release agent composition, in the release agent layer formed from the release agent composition, the Novolac resin absorbs light (for example, laser light) to change properties (for example, separation or decomposition) of the release agent layer. As a result, after the release agent layer is irradiated with light, the semiconductor substrate is easily released from the support substrate.

In addition, while the electronic device layer is subjected to processing such as thinning, the electronic device layer is supported by the support substrate. On the other hand, after the processing of the electronic device layer, the release agent layer is irradiated with light, and thereafter, the support substrate and the electronic device layer are separated from each other.

With the release agent layer according to the present invention, the semiconductor substrate or the electronic device layer is easily released from the support substrate after being irradiated with light. Furthermore, after the semiconductor substrate or the electronic device layer is released from the support substrate, residues of the release agent layer or the adhesive layer remaining on the semiconductor substrate, the electronic device layer, or the support substrate can be removed by, for example, a cleaning agent composition for cleaning the semiconductor substrate or the like.

The wavelength of light used for release is preferably, for example, a wavelength of 250 to 600 nm, and more preferably a wavelength of 250 to 370 nm. A more suitable wavelength is 308 nm, 343 nm, 355 nm, 365 nm, or 532 nm. The irradiation amount of light required for release is an irradiation amount that can cause suitable change in properties, for example, decomposition of the Novolac resin.

The light used for release may be laser light or non-laser light emitted from a light source such as an ultraviolet lamp.

Hereinafter, a case where the laminate has a semiconductor substrate and a case where the laminate has an electronic device layer will be described in detail separately.

A case where the laminate has a semiconductor substrate will be described in the following <First Embodiment>, and a case where the laminate has an electronic device layer will be described in the following <Second Embodiment>.

### <First Embodiment>

A laminate having a semiconductor substrate is used for processing a semiconductor substrate. While the semiconductor substrate is processed, the semiconductor substrate is adhered to the support substrate. After processing the semiconductor substrate, the release agent layer is irradiated with light, and then the semiconductor substrate is separated from the support substrate.

### <<Semiconductor Substrate>>

The main material constituting the entire semiconductor substrate is not particularly limited as long as the material is used for this type of application, and examples thereof include silicon, silicon carbide, and a compound semiconductor.

The shape of the semiconductor substrate is not particularly limited, and is, for example, a disk shape. Note that the disk-shaped semiconductor substrate does not need to have a completely circular surface, and for example, the outer periphery of the semiconductor substrate may have a linear portion called an orientation flat or may have a cut called a notch.

The thickness of the disk-shaped semiconductor substrate may be appropriately determined according to the purpose of use of the semiconductor substrate and the like, and is not particularly limited, but is, for example, 500 to 1,000 µm.

The diameter of the disk-shaped semiconductor substrate may be appropriately determined according to the purpose of use of the semiconductor substrate and the like, and is not particularly limited, but is, for example, 100 to 1,000 mm.

The semiconductor substrate may have a bump. The bump is a protruding terminal.

In the laminate, when the semiconductor substrate has a bump, the semiconductor substrate has a bump on the support substrate side.

In a semiconductor substrate, a bump is usually formed on a surface on which a circuit is formed. The circuit may be a single layer or a multilayer. The shape of the circuit is not particularly limited.

In the semiconductor substrate, a surface (back surface) opposite to the surface having the bump is a surface to be used for processing.

The material, size, shape, structure, and density of the bump of the semiconductor substrate are not particularly limited.

Examples of the bump include a ball bump, a print bump, a stud bump, and a plating bump.

Usually, the height, radius, and pitch of the bump are appropriately determined from the conditions of a bump height of approximately 1 to 200 µm, a bump radius of 1 to 200 µm, and a bump pitch of 1 to 500 µm.

Examples of the material of the bump include low melting point solder, high melting point solder, tin, indium, gold, silver, and copper. The bump may be composed of only a single component or may be composed of a plurality of components. More specific examples thereof include alloy plating mainly containing Sn, such as SnAg bumps, SnBi bumps, Sn bumps, and AuSn bumps.

In addition, the bump may have a laminated structure including a metal layer made of at least one of these components.

An example of the semiconductor substrate is a silicon wafer having a diameter of approximately 300 mm and a thickness of approximately 770 µm.

### <<Support Substrate>>

The support substrate is not particularly limited as long as the support substrate is a member that is light transmissive to light emitted to the release agent layer and can support the semiconductor substrate when the semiconductor substrate is processed, and examples thereof include a glass support substrate.

The shape of the support substrate is not particularly limited, and examples thereof include a disk shape.

The thickness of the disk-shaped support substrate may be appropriately determined according to the size of the semiconductor substrate and the like, and is not particularly limited, but is, for example, 500 to 1,000 µm.

The diameter of the disk-shaped support substrate may be appropriately determined according to the size of the semiconductor substrate and the like, and is not particularly limited, but is, for example, 100 to 1,000 mm.

An example of the support substrate is a glass wafer having a diameter of approximately 300 mm and a thickness of approximately 700 µm.

### <<Release Agent Layer>>

The release agent layer is a layer formed from a release agent composition.

The release agent layer is provided between the semiconductor substrate and the support substrate.

The release agent layer may be in contact with the support substrate or may be in contact with the semiconductor substrate.

The release agent layer is formed using the release agent composition for photoirradiation release of the present invention described above.

The release agent composition of the present invention can be suitably used for forming a release agent layer of a laminate including a semiconductor substrate, a support substrate, and a release agent layer provided between the semiconductor substrate and the support substrate. The laminate is used for releasing the semiconductor substrate from the support substrate after the release agent layer absorbs light emitted from the support substrate side.

One of the characteristics of the release agent layer obtained from the release agent composition of the present invention is that the semiconductor substrate can be easily released from the support substrate after photoirradiation.

When the release agent layer is formed from the release agent composition, the Novolac resin itself may be crosslinked or react with other components to form a crosslinked structure, or the structure may be maintained without crosslinking or reacting as long as the effect of the present invention is obtained.

In other words, in the release agent layer, the Novolac resin may form a crosslinked structure either by crosslinking itself or reacting with other components, or may exist while maintaining the structure.

The thickness of the release agent layer is not particularly limited, but is usually 0.01 to 15 µm, and is preferably 0.05 µm to 10 µm, more preferably 0.1 µm to 8 µm, and still more preferably 0.2 µm to 5 µm from the viewpoint of maintaining the film strength.

When a release agent layer is formed on a semiconductor substrate having a bump, the thickness of the release agent layer is preferably 0.5 µm to 10 µm.

The method for forming the release agent layer from the release agent composition will be described in detail in the description of <<Method for Producing One Example of Laminate in First Embodiment>> described below.

### <<Adhesive Layer>>

The adhesive layer is provided between the support substrate and the semiconductor substrate.

The adhesive layer is in contact with, for example, the semiconductor substrate. The adhesive layer may be in contact with, for example, the support substrate.

The adhesive layer is not particularly limited, but is preferably a layer formed from an adhesive composition.

### <<Adhesive Composition>>

Examples of the adhesive composition include a polysiloxane-based adhesive, an acrylic resin-based adhesive, an epoxy resin-based adhesive, a polyamide-based adhesive, a polystyrene-based adhesive, a polyimide adhesive, and a phenol resin-based adhesive, but are not limited thereto.

Among them, a polysiloxane-based adhesive is preferable as the adhesive composition because the adhesive composition exhibits suitable adhesive function during processing of a semiconductor substrate or the like, can be suitably released after processing, is further excellent in heat resistance, and can be suitably removed by the cleaning agent composition.

In a preferred aspect, the adhesive composition contains a polyorganosiloxane.

In another preferred aspect, the adhesive composition contains a component to be cured by a hydrosilylation reaction.

For example, the adhesive composition used in the present invention contains a component (A) to be cured to be an adhesive component. The adhesive composition used in the present invention may contain a component (A) to be cured to be an adhesive component and a component (B) that does not cause a curing reaction. Here, examples of the component (B) that does not cause a curing reaction include polyorganosiloxanes. In the present invention, "does not cause a curing reaction" does not mean that any curing reaction does not occur, but means that a curing reaction occurring in the component (A) to be cured does not occur.

In a preferred aspect, the component (A) may be a component to be cured by a hydrosilylation reaction or a polyorganosiloxane component (A') to be cured by a hydrosilylation reaction.

In another preferred aspect, the component (A) contains, for example, as an example of the component (A'), a polyorganosiloxane (a1) having an alkenyl group having 2 to 40 carbon atoms bonded to a silicon atom, a polyorganosiloxane (a2) having a Si-H group, and a platinum group metal-based catalyst (A2). Here, the alkenyl group having 2 to 40 carbon atoms is optionally substituted. Examples of the substituent include a halogen atom, a nitro group, a cyano group, an amino group, a hydroxy group, a carboxyl group, an aryl group, and a heteroaryl group.

In another preferred aspect, the polyorganosiloxane component (A') to be cured by the hydrosilylation reaction includes a polysiloxane (A1) containing one or more units selected from the group consisting of siloxane units (Q units) represented by SiO₂, siloxane units (M units) represented by R¹R²R³SiO_{1/2}, siloxane units (D units) represented by R⁴R⁵SiO_{2/2}, and siloxane units (T units) represented by R^{P}SiO_{3/2}, and a platinum group metal-based catalyst (A2), and the polysiloxane (A1) includes a polyorganosiloxane (al') containing one or more units selected from the group consisting of siloxane units (Q' units) represented by SiO₂, siloxane units (M' units) represented by R¹'R²'R³'SiO_{1/2}, siloxane units (D' units) represented by R⁴'R⁵'SiO_{2/2}, and siloxane units (T' units) represented by R⁶'SiO_{3/2}, and containing at least one selected from the group consisting of M' units, D' units, and T' units, and a polyorganosiloxane (a2') containing one or more units selected from the group consisting of siloxane units (Q" units) represented by SiO₂, siloxane units (M" units) represented by R¹"R²"R³"SiO_{1/2}, siloxane units (D" units) represented by R⁴"R⁵"SiO_{2/2}, and siloxane units (T" units) represented by R⁶"SiO_{3/2}, and containing at least one selected from the group consisting of M" units, D" units, and T" units.

Note that (al') is an example of (a1), and (a2') is an example of (a2).

R¹ to R⁶ are groups or atoms bonded to a silicon atom, and each independently represent an optionally substituted alkyl group, an optionally substituted alkenyl group, or a hydrogen atom. Examples of the substituent include a halogen atom, a nitro group, a cyano group, an amino group, a hydroxy group, a carboxyl group, an aryl group, and a heteroaryl group.

R¹' to R⁶' are groups bonded to a silicon atom, and each independently represent an optionally substituted alkyl group or an optionally substituted alkenyl group, but at least one of R¹' to R⁶' is an optionally substituted alkenyl group. Examples of the substituent include a halogen atom, a nitro group, a cyano group, an amino group, a hydroxy group, a carboxyl group, an aryl group, and a heteroaryl group.

R¹" to R⁶" are groups or atoms bonded to a silicon atom, and each independently represent an optionally substituted alkyl group or a hydrogen atom, but at least one of R¹" to R⁶" is a hydrogen atom. Examples of the substituent include a halogen atom, a nitro group, a cyano group, an amino group, a hydroxy group, a carboxyl group, an aryl group, and a heteroaryl group.

The alkyl group may be linear, branched, or cyclic, but is preferably a linear or branched alkyl group, and the number of carbon atoms thereof is not particularly limited, but is usually 1 to 40, preferably 30 or less, more preferably 20 or less, and still more preferably 10 or less.

Specific examples of the optionally substituted linear or branched alkyl group include a methyl group, an ethyl group, an n-propyl group, an i-propyl group, an n-butyl group, an i-butyl group, an s-butyl group, a tertiary butyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, an n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1 methyl-n-propyl group, and a 1-ethyl-2 methyl-n-propyl group, but are not limited thereto, and the number of carbon atoms thereof is usually 1 to 14, preferably 1 to 10, and more preferably 1 to 6. Among them, a methyl group is particularly preferable.

Specific examples of the optionally substituted cyclic alkyl group include a cycloalkyl group such as a cyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group; and a bicycloalkyl group such as a bicyclobutyl group, a bicyclopentyl group, a bicyclohexyl group, a bicycloheptyl group, a bicyclooctyl group, a bicyclononyl group, and a bicyclodecyl group, but are not limited thereto, and the number of carbon atoms thereof is usually 3 to 14, preferably 4 to 10, and more preferably 5 to 6.

The alkenyl group may be linear or branched, and the number of carbon atoms thereof is not particularly limited, but is usually 2 to 40, and is preferably 30 or less, more preferably 20 or less, and still more preferably 10 or less.

Specific examples of the optionally substituted linear or branched alkenyl group include a vinyl group, an allyl group, a butenyl group, and a pentenyl group, but are not limited thereto, and the number of carbon atoms thereof is usually 2 to 14, preferably 2 to 10, and more preferably 1 to 6. Among them, an ethenyl group and a 2-propenyl group are particularly preferable.

Specific examples of the optionally substituted cyclic alkenyl group include cyclopentenyl and cyclohexenyl, but are not limited thereto, and the number of carbon atoms thereof is usually 4 to 14, preferably 5 to 10, and more preferably 5 to 6.

As described above, the polysiloxane (A1) contains a polyorganosiloxane (al') and a polyorganosiloxane (a2'), and an alkenyl group contained in the polyorganosiloxane (al') and a hydrogen atom (Si-H group) contained in the polyorganosiloxane (a2') form a crosslinked structure by a hydrosilylation reaction by the platinum group metal-based catalyst (A2) and are cured. As a result, a cured film is formed.

The polyorganosiloxane (al') contains one or more units selected from the group consisting of Q' units, M' units, D' units, and T' units, and contains at least one selected from the group consisting of M' units, D' units, and T' units. As the polyorganosiloxane (a1'), two or more types of polyorganosiloxanes satisfying such conditions may be used in combination.

Preferred combinations of two or more selected from the group consisting of Q' units, M' units, D' units, and T' units include, but are not limited to, (Q' units and M' units), (D' units and M' units), (T' units and M' units), and (Q' units, T' units, and M' units).

In addition, when two or more types of polyorganosiloxanes included in polyorganosiloxane (al') is contained, a combination of (Q' units and M' units) and (D' units and M' units), a combination of (T' units and M' units) and (D' units and M' units), and a combination of (Q' units, T' units, and M' units) and (T' units and M' units) are preferable, but the combinations are not limited thereto.

The polyorganosiloxane (a2') contains one or more units selected from the group consisting of Q" units, M" units, D" units, and T" units, and contains at least one selected from the group consisting of M" units, D" units, and T" units. As the polyorganosiloxane (a2'), two or more types of polyorganosiloxanes satisfying such conditions may be used in combination.

Preferred combinations of two or more selected from the group consisting of Q" units, M" units, D" units, and T" units include (M" units and D" units), (Q" units and M" units), and (Q" units, T" units, and M" units), but are not limited thereto.

The polyorganosiloxane (al') is composed of siloxane units in which alkyl groups and/or alkenyl groups are bonded to silicon atoms thereof, and the proportion of alkenyl groups in the total substituents represented by R¹' to R⁶' is preferably 0.1 to 50.0% by mol and more preferably 0.5 to 30.0% by mol, and the remaining R¹' to R⁶' can be alkyl groups.

The polyorganosiloxane (a2') is composed of siloxane units in which alkyl groups and/or hydrogen atoms are bonded to silicon atoms thereof, and the proportion of hydrogen atoms in all substituents represented by R¹" to R⁶" and substituted atoms is preferably 0.1 to 50.0% by mol and more preferably 10.0 to 40.0% by mol, and the remaining R¹" to R⁶" can be alkyl groups.

When the component (A) contains (a1) and (a2), in a preferred aspect of the present invention, the molar ratio of the alkenyl group contained in the polyorganosiloxane (a1) and the hydrogen atom constituting the Si-H bond contained in the polyorganosiloxane (a2) is in the range of 1.0:0.5 to 1.0:0.66.

The weight average molecular weight of the polysiloxane such as the polyorganosiloxane (a1) or the polyorganosiloxane (a2) is not particularly limited, but each is typically 500 to 1,000,000, and is preferably 5,000 to 50,000 from the viewpoint of realizing the effects of the present invention with good reproducibility.

In the present invention, the weight average molecular weight, the number average molecular weight, and the dispersibility of the polyorganosiloxane (excluding the organosiloxane polymer) can be measured, for example, using a GPC apparatus (EcoSEC, HLC-8320GPC manufactured by Tosoh Corporation) and a GPC column (TSKgel SuperMultiporeHZ-N and TSKgel SuperMultiporeHZ-H manufactured by Tosoh Corporation), at a column temperature of 40°C, using tetrahydrofuran as an eluent (eluent solvent), at a flow rate of 0.35 mL/min, and using polystyrene (Shodex manufactured by Showa Denko K.K.) as a standard sample.

The viscosity of the polyorganosiloxane (a1) and the polyorganosiloxane (a2) is not particularly limited, but each is typically 10 to 1,000,000 (mPa·s), and is preferably 50 to 10,000 (mPa·s) from the viewpoint of realizing the effects of the present invention with good reproducibility. In addition, the viscosity of the polyorganosiloxane (a1) and the polyorganosiloxane (a2) are values measured with an E-type rotational viscometer at 25°C.

The polyorganosiloxane (a1) and the polyorganosiloxane (a2) react with each other by a hydrosilylation reaction to form a film. Therefore, the mechanism of curing is different from a mechanism, for example, through silanol groups, and therefore, any siloxane does not need to contain a functional group that forms a silanol group by hydrolysis, such as a silanol group or an alkyloxy group.

In a preferred aspect of the present invention, the adhesive composition contains a platinum group metal-based catalyst (A2) together with the polyorganosiloxane component (A').

Such a platinum-based metal catalyst is a catalyst for promoting the hydrosilylation reaction between the alkenyl group of the polyorganosiloxane (a1) and the Si-H group of the polyorganosiloxane (a2).

Specific examples of the platinum-based metal catalyst include platinum-based catalysts such as platinum black, second platinum chloride, chloroplatinic acid, a reaction product of chloroplatinic acid and monohydric alcohol, a complex of chloroplatinic acid and olefins, and platinum bisacetoacetate, but are not limited thereto.

Examples of the complex of platinum and olefins include a complex of divinyltetramethyldisiloxane and platinum, but are not limited thereto.

The amount of the platinum group metal-based catalyst (A2) is not particularly limited, but is usually in the range of 1.0 to 50.0 ppm with respect to the total amount of the polyorganosiloxane (a1) and the polyorganosiloxane (a2).

The polyorganosiloxane component (A') may contain a polymerization inhibitor (A3) for the purpose of suppressing the progress of the hydrosilylation reaction.

The polymerization inhibitor is not particularly limited as long as it is possible to suppress the progress of the hydrosilylation reaction, and specific examples thereof include alkynyl alcohols such as 1-ethynyl-1-cyclohexanol and 1,1-diphenyl-2-propion-1-ol.

The amount of the polymerization inhibitor is not particularly limited, but is usually 1,000.0 ppm or more with respect to the total amount of the polyorganosiloxane (a1) and the polyorganosiloxane (a2) from the viewpoint of obtaining the effect, and is 10,000.0 ppm or less from the viewpoint of preventing excessive suppression of the hydrosilylation reaction.

An example of the adhesive composition used in the present invention may include the component (A) to be cured and the component (B) that does not cause a curing reaction as a release agent component. By including such a component (B) in the adhesive composition, the obtained adhesive layer can be suitably released with good reproducibility.

Typical examples of the component (B) include non-curable polyorganosiloxanes, and specific examples thereof include epoxy group-containing polyorganosiloxanes, methyl group-containing polyorganosiloxanes, and phenyl group-containing polyorganosiloxanes, but are not limited thereto.

Examples of the component (B) include polydimethylsiloxane. The polydimethylsiloxane may be modified. Examples of the polydimethylsiloxane which may be modified include epoxy group-containing polydimethylsiloxane, unmodified polydimethylsiloxane, and phenyl group-containing polydimethylsiloxane, but are not limited to.

Preferred examples of the polyorganosiloxane as the component (B) include epoxy group-containing polyorganosiloxanes, methyl group-containing polyorganosiloxanes, and phenyl group-containing polyorganosiloxanes, but are not limited thereto.

The weight average molecular weight of the polyorganosiloxane as the component (B) is not particularly limited, but is usually 100,000 to 2,000,000, and is preferably 200,000 to 1,200,000, more preferably 300,000 to 900,000 from the viewpoint of realizing the effects of the present invention with good reproducibility. In addition, the dispersibility is not particularly limited, but is usually 1.0 to 10.0, and is preferably 1.5 to 5.0, and more preferably 2.0 to 3.0 from the viewpoint of realizing suitable releasing with good reproducibility. In addition, the weight average molecular weight and the dispersibility can be measured by the above-described method related to the polyorganosiloxane.

The viscosity of the polyorganosiloxane as the component (B) is not particularly limited, but is usually 1,000 to 2,000,000 mm²/s. In addition, the value of the viscosity of the polyorganosiloxane as the component (B) is expressed by kinematic viscosity, and centistokes (cSt) = mm²/s. The value can also be determined by dividing the viscosity (mPa·s) by the density (g/cm³). That is, the value can be determined from the viscosity and density measured with an E-type rotational viscometer measured at 25°C, and can be calculated from the equation: kinematic viscosity (mm²/s) = viscosity (mPa ·s) /density (g/cm³).

Examples of the epoxy group-containing polyorganosiloxane include those containing siloxane units (D¹⁰ units) represented by R¹¹R¹²SiO_{2/2}.

R¹¹ is a group bonded to a silicon atom and represents an alkyl group, R¹² is a group bonded to a silicon atom and represents an epoxy group or an organic group containing an epoxy group, and specific examples of the alkyl group can include the above-described examples.

The epoxy group in the organic group containing an epoxy group may be an independent epoxy group without being condensed with other rings, or may be an epoxy group forming a condensed ring with other rings, such as a 1,2-epoxycyclohexyl group.

Specific examples of the organic group containing an epoxy group include, but are not limited to, 3-glycidoxypropyl and 2-(3,4-epoxycyclohexyl)ethyl.

In the present invention, preferred examples of the epoxy group-containing polyorganosiloxane include epoxy group-containing polydimethylsiloxane, but are not limited thereto.

The epoxy group-containing polyorganosiloxane contains the above-described siloxane units (D¹⁰ units), but may contain Q units, M units, and/or T units in addition to the D¹⁰ units.

In a preferred aspect of the present invention, specific examples of the epoxy group-containing polyorganosiloxane include polyorganosiloxanes composed only of D¹⁰ units, polyorganosiloxanes containing D¹⁰ units and Q units, polyorganosiloxanes containing D¹⁰ units and M units, polyorganosiloxanes containing D¹⁰ units and T units, polyorganosiloxanes containing D¹⁰ units, Q units, and M units, polyorganosiloxanes containing D¹⁰ units, M units, and T units, and polyorganosiloxanes containing D¹⁰ units, Q units, M units, and T units.

The epoxy group-containing polyorganosiloxane is preferably an epoxy group-containing polydimethylsiloxane having an epoxy value of 0.1 to 5. The weight average molecular weight thereof is not particularly limited, but is usually 1,500 to 500,000, and is preferably 100,000 or less from the viewpoint of suppressing precipitation in the composition.

Specific examples of the epoxy group-containing polyorganosiloxane include those represented by Formulas (E1) to (E3), but are not limited thereto. 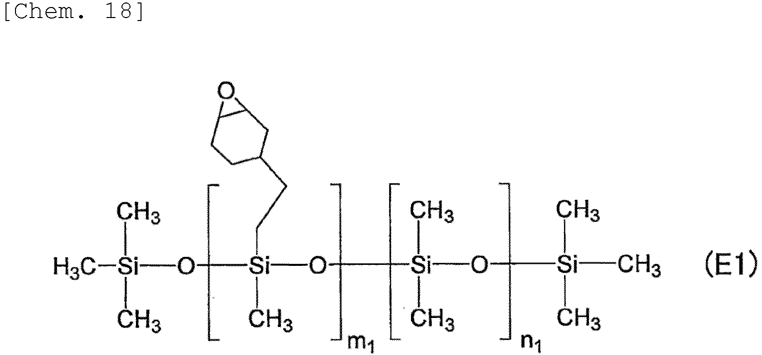 (m₁ and n₁ represent the number of each repeating unit, and are positive integers.) 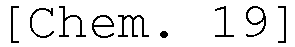 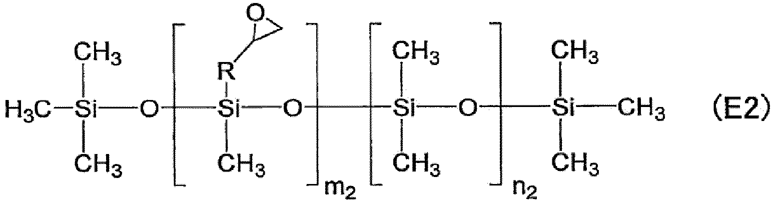 (m₂ and n₂ represent the number of each repeating unit and are positive integers, and R is an alkylene group having 1 to 10 carbon atoms.) 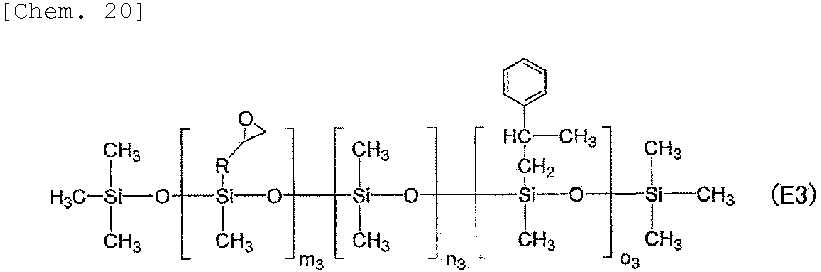 (m₃, n₃, and o₃ represent the number of each repeating unit, and are positive integers, and R is an alkylene group having 1 to 10 carbon atoms.)

Examples of the methyl group-containing polyorganosiloxane include those containing siloxane units (D²⁰⁰ units) represented by R²¹⁰R²²⁰SiO_{2/2}, and those containing siloxane units (D²⁰ units) preferably represented by R²¹R²¹SiO_{2/2}.

R²¹⁰ and R²²⁰ are groups bonded to a silicon atom, and each independently represent an alkyl group, but at least one thereof is a methyl group, and specific examples of the alkyl group can include the above-described examples.

R²¹ is a group bonded to a silicon atom and represents an alkyl group, and specific examples of the alkyl group can include the above-described examples. Among them, R²¹ is preferably a methyl group.

In the present invention, preferred examples of the methyl group-containing polyorganosiloxane include polydimethylsiloxane, but are not limited thereto.

The methyl group-containing polyorganosiloxane contains the above-described siloxane units (D²⁰⁰ units or D²⁰ units), but may contain Q units, M units, and/or T units in addition to D²⁰⁰ units and D²⁰ units.

In an aspect of the present invention, specific examples of the methyl group-containing polyorganosiloxane include polyorganosiloxanes composed only of D²⁰⁰ units, polyorganosiloxanes containing D²⁰⁰ units and Q units, polyorganosiloxanes containing D²⁰⁰ units and M units, polyorganosiloxanes containing D²⁰⁰ units and T units, polyorganosiloxanes containing D²⁰⁰ units, Q units, and M units, polyorganosiloxanes containing D²⁰⁰ units, M units, and T units, and polyorganosiloxanes containing D²⁰⁰ units, Q units, M units, and T units.

In a preferred aspect of the present invention, specific examples of the methyl group-containing polyorganosiloxane include polyorganosiloxanes composed only of D²⁰ units, polyorganosiloxanes containing D²⁰ units and Q units, polyorganosiloxanes containing D²⁰ units and M units, polyorganosiloxanes containing D²⁰ units and T units, polyorganosiloxanes containing D²⁰ units, Q units, and M units, polyorganosiloxanes containing D²⁰ units, M units, and T units, and polyorganosiloxanes containing D²⁰ units, Q units, M units, and T units.

Specific examples of the methyl group-containing polyorganosiloxane include those represented by Formula (M1), but are not limited thereto. 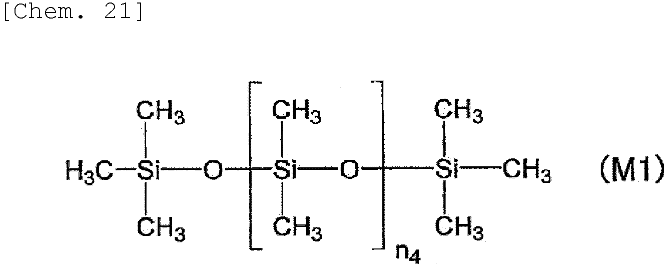 (n₄ represents the number of repeating units, and is a positive integer.)

Examples of the phenyl group-containing polyorganosiloxane include those containing siloxane units (D³⁰ units) represented by R³¹R³²SiO_{2/2}.

R³¹ is a group bonded to a silicon atom and represents a phenyl group or an alkyl group, R³² is a group bonded to a silicon atom and represents a phenyl group, and specific examples of the alkyl group include the above-described examples, but a methyl group is preferable.

The phenyl group-containing polyorganosiloxane contains the above-described siloxane units (D³⁰ units), but may contain Q units, M units, and/or a T units in addition to the D³⁰ units.

In a preferred aspect of the present invention, specific examples of the phenyl group-containing polyorganosiloxane include polyorganosiloxanes composed only of D³⁰ units, polyorganosiloxanes containing D³⁰ units and Q units, polyorganosiloxanes containing D³⁰ units and M units, polyorganosiloxanes containing D³⁰ units and T units, polyorganosiloxanes containing D³⁰ units, Q units, and M units, polyorganosiloxanes containing D³⁰ units, M units, and T units, and polyorganosiloxanes containing D³⁰ units, Q units, M units, and T units.

Specific examples of the phenyl group-containing polyorganosiloxane include those represented by Formulas (P1) or (P2), but are not limited thereto. 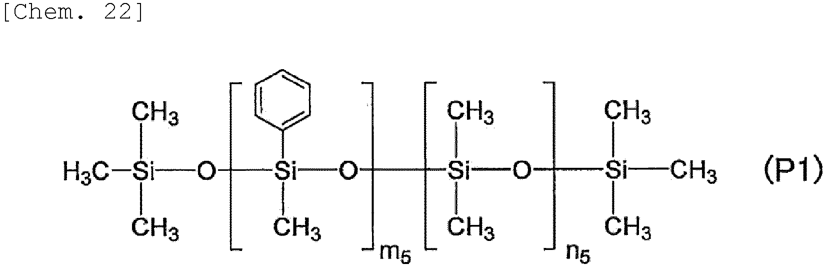 (m₅ and n₅ represent the number of each repeating unit, and are positive integers.) 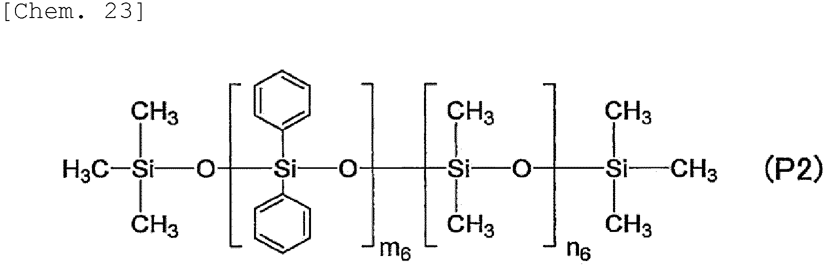 (m₆ and n₆ represent the number of each repeating unit, and are positive integers.)

The polyorganosiloxane as the release agent component (B) may be a commercially available product or a synthetic product.

Examples of commercially available products of the polyorganosiloxane include Wacker Silicone Fluids AK series (AK 50, AK 350, AK 1000, AK 10000, AK 1000000) and GENIOPLAST GUM, which are products manufactured by Wacker Chemie AG, dimethyl silicone oil (KF-96L, KF-96A, KF-96, KF-96H, KF-69, KF-965, KF-968) and cyclic dimethyl silicone oil (KF-995) manufactured by Shin-Etsu Chemical Co., Ltd.; epoxy group-containing polyorganosiloxane manufactured by Gelest, Inc. (trade name: CMS-227, ECMS-327), epoxy group-containing polyorganosiloxane manufactured by Shin-Etsu Chemical Co., Ltd. (KF-101, KF-1001, KF-1005, X-22-343), epoxy group-containing polyorganosiloxane manufactured by Dow Corning Corporation (BY16-839); and phenyl group-containing polyorganosiloxane (PMM-1043, PMM-1025, PDM-0421, PDM-0821) manufactured by Gelest, Inc., phenyl group-containing polyorganosiloxane (KF50-3000CS) manufactured by Shin-Etsu Chemical Co., Ltd., and phenyl group-containing polyorganosiloxane (TSF431, TSF433) manufactured by Momentive Performance Materials, Inc., but are not limited thereto.

In one aspect, the adhesive composition used in the present invention contains a component (A) to be cured and a component (B) that does not cause a curing reaction, and in another aspect, a polyorganosiloxane is contained as the component (B).

An example of the adhesive composition used in the present invention can contain the component (A) and the component (B) in any ratio, but in consideration of the balance between adhesiveness and releasability, the ratio of the component (A) and the component (B) is preferably 99.995:0.005 to 30:70, and more preferably 99.9:0.1 to 75:25 in mass ratio [(A): (B)].

That is, when the polyorganosiloxane component (A') to be cured by a hydrosilylation reaction is contained, the ratio of the component (A') and the component (B) is preferably 99.995:0.005 to 30:70, and more preferably 99.9:0.1 to 75:25 in mass ratio [(A'):(B)].

The viscosity of the adhesive composition used in the present invention is not particularly limited, but is usually 500 to 20,000 mPa·s, and preferably 1,000 to 1, 0000 mPa·s at 25°C.

An example of the adhesive composition used in the present invention can be produced by mixing the component (A) and, if used, the component (B) and a solvent.

The mixing order is not particularly limited, but examples of the method, by which the adhesive composition can be easily produced with good reproducibility, include, for example, a method in which the component (A) and the component (B) are dissolved in a solvent, and a method in which a part of the component (A) and the component (B) is dissolved in a solvent, the rest is dissolved in a solvent, and the obtained solution is mixed. When the adhesive composition is prepared, the adhesive composition may be appropriately heated as long as the components are not decomposed or changed in properties.

In the present invention, for the purpose of removing foreign substances, a solvent, a solution, or the like to be used may be filtered using a filter or the like during the production of the adhesive composition or after mixing all the components.

The thickness of the adhesive layer included in the laminate of the present invention is not particularly limited, but is usually 5 to 500 µm, and is preferably 10 µm or more, more preferably 20 µm or more, and still more preferably 30 µm or more from the viewpoint of maintaining the film strength, and is preferably 200 µm or less, more preferably 150 µm or less, still more preferably 120 µm or less, and still more preferably 70 µm or less from the viewpoint of avoiding nonuniformity caused by a thick film.

The method for forming the adhesive layer from the adhesive composition will be described in detail in the description of <<Method for Producing One Example of Laminate in First Embodiment>> described below.

Hereinafter, an example of the configuration of the laminate of the first embodiment will be described with reference to the drawings.

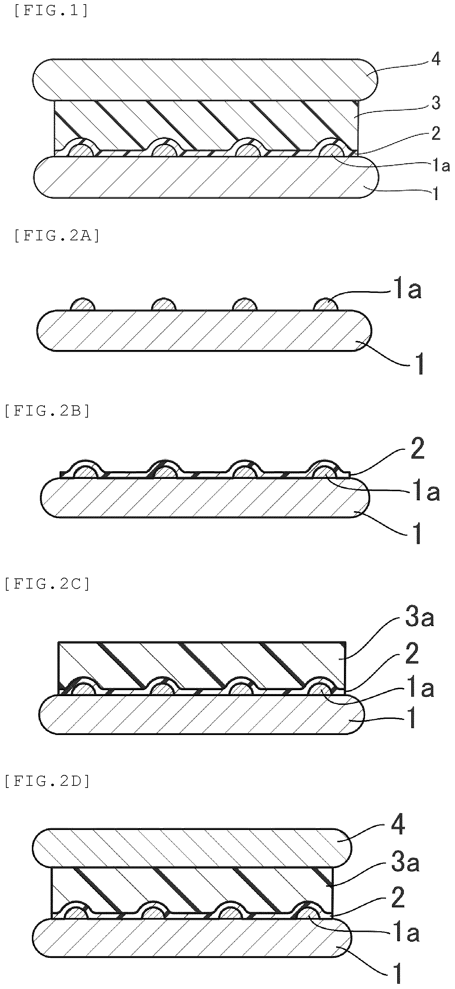

Fig. 1 shows a schematic cross-sectional view of an example of a laminate of the first embodiment.

The laminate of Fig. 1 includes a semiconductor substrate 1 having a bump 1a, a release agent layer 2, an adhesive layer 3, and a support substrate 4 in this order.

The bump 1a of the semiconductor substrate 1 is disposed on the support substrate 4 side.

The release agent layer 2 is interposed between the semiconductor substrate 1 and the support substrate 4. The release agent layer 2 is in contact with the semiconductor substrate 1. In addition, the release agent layer 2 covers the bump 1a.

The adhesive layer 3 is interposed between the release agent layer 2 and the support substrate 4. The adhesive layer 3 is in contact with the release agent layer 2 and the support substrate 4.

The thickness of the release agent layer 2 is, for example, 0.5 µm to 10 µm, and this thickness can cover a semiconductor substrate having bumps having a height of approximately 30 µm to 40 µm.

### <<Method for Producing One Example of Laminate in First Embodiment>>

A method for producing a laminate will be described below with the laminate shown in Fig. 1 as an example of the laminate in the first embodiment.

An example of the laminate of the present invention can be produced, for example, by a method including the following Steps 1 to 3.

Step 1: a step of forming a release agent layer by coating the surface of the semiconductor substrate on which a bump is present with a release agent composition

Step 2: a step of forming an adhesive coating layer by coating the surface of the release agent layer with an adhesive composition

Step 3: a step of forming an adhesive layer by heating the adhesive coating layer in a state where the support substrate and the adhesive coating layer are in contact with each other and the adhesive coating layer and the release agent layer are in contact with each other.

The method for coating the release agent composition is not particularly limited, but is usually a spin coating method.

The heating temperature of the applied release agent composition varies depending on the type and amount of the release agent component contained in the release agent composition, the desired thickness of the release agent layer, and the like, and thus cannot be generally defined, but from the viewpoint of realizing a suitable release agent layer with good reproducibility, the heating temperature is 80°C or more and 300°C or less, and the heating time is appropriately determined usually in the range of 10 seconds to 10 minutes depending on the heating temperature. The heating temperature is preferably 100°C or higher and 280°C or lower, and more preferably 150°C or higher and 250°C or lower. The heating time is preferably 30 seconds or more and 8 minutes or less, and more preferably 1 minute or more and 5 minutes or less.

Heating can be performed using a hot plate, an oven, or the like.

The film thickness of the release agent layer obtained by applying the release agent composition and heating the release agent composition if necessary is usually approximately 5 nm to 100 µm.

The method for coating the adhesive composition is not particularly limited, but is usually a spin coating method. Incidentally, a method for separately forming a coating film by a spin coating method or the like, forming a sheet-like coating film, and sticking the sheet-like coating film as an adhesive coating layer can be adopted.

The heating temperature of the applied adhesive composition varies depending on the type and amount of the adhesive component contained in the adhesive composition, whether or not a solvent is contained, the boiling point of the solvent used, the desired thickness of the adhesive layer, and the like, and thus cannot be generally specified, but the heating temperature is usually 80 to 150°C, and the heating time is usually 30 seconds to 5 minutes.

When the adhesive composition contains a solvent, the applied adhesive composition is usually heated.

The film thickness of an adhesive coating layer obtained by applying an adhesive composition and heating the adhesive composition as necessary is usually approximately 5 to 500 µm, and finally, is appropriately determined to fall within the above-described range of the thickness of the adhesive layer.

In the present invention, the laminate of the present invention can be obtained by combining such coating layers to be in contact with each other, applying a load in the thickness direction of the semiconductor substrate and the support substrate to bring the two layers into close contact with each other while performing a heat treatment or a pressure reduction treatment or both, and then performing a post-heat treatment. Which treatment condition of heat treatment, pressure reduction treatment, and combination use of both is adopted is appropriately determined in consideration of various circumstances such as the type of the adhesive composition, the specific composition of the release agent composition, the compatibility of the films obtained from both compositions, the film thickness, and the required adhesive strength.

The heat treatment is appropriately determined from the range of usually 20 to 150°C from the viewpoint of removing the solvent from the composition, the viewpoint of softening the adhesive coating layer to realize suitable bonding with the release agent layer, and the like. In particular, from the viewpoint of suppressing or avoiding excessive curing and unnecessary change in properties of the adhesive component (A), the heating temperature is preferably 130°C or lower, more preferably 90°C or lower, and the heating time is appropriately determined according to the heating temperature and the type of the adhesive. However, from the viewpoint of reliably exhibiting suitable adhesion, the heating time is usually 30 seconds or longer, and preferably 1 minute or longer, but from the viewpoint of suppressing t of the change in properties of the adhesive layer and other members, the heating time is usually 10 minutes or shorter, and preferably 5 minutes or shorter.

In the pressure reduction treatment, the adhesive coating layer and the release agent layer in contact with each other may be exposed to an atmospheric pressure of 10 to 10,000 Pa. The time for the pressure reduction treatment is usually 1 to 30 minutes.

From the viewpoint of obtaining a laminate in which the substrate can be satisfactorily separated with good reproducibility, the two layers in contact with each other are bonded to each other preferably by pressure reduction treatment, and more preferably by combined use of heat treatment and pressure reduction treatment.

The load in the thickness direction of the semiconductor substrate and the support substrate is not particularly limited as long as the load does not adversely affect the semiconductor substrate and the support substrate and the two layers therebetween and can bring the two layers into close contact with each other, but is usually within the range of 10 to 1,000 N.

The post-heating temperature is preferably 120°C or higher from the viewpoint of realizing a sufficient curing rate and the like, and is preferably 260°C or lower from the viewpoint of preventing the change in properties of the substrate or each layer and the like.

The post-heating time is usually 1 minute or more, and preferably 5 minutes or more from the viewpoint of realizing suitable bonding of the substrate and the layer constituting the laminate, and is usually 180 minutes or less, and preferably 120 minutes or less from the viewpoint of suppressing or avoiding an adverse effect on each layer due to excessive heating.

Heating can be performed using a hot plate, an oven, or the like. When post-heating is performed using a hot plate, heating may be performed with either the semiconductor substrate or the support substrate of the laminate facing downward, but it is preferable to perform post-heating with the semiconductor substrate facing downward from the viewpoint of realizing suitable releasing with good reproducibility.

In addition, one object of the post-heat treatment is to realize an adhesive layer and a release agent layer which are more suitable self-standing films, and particularly to suitably realize curing by a hydrosilylation reaction.

Hereinafter, an example of the method for producing a laminate of Fig. 1 will be described with reference to Figs. 2A to 2E.

Figs. 2A to 2E are views for explaining one aspect of producing a laminate.

First, the semiconductor substrate 1 having the bumps 1a is prepared (Fig. 2A).

Next, the surface of the semiconductor substrate 1 on which the bump 1a is present is coated with the release agent composition to form the release agent layer 2 (Fig. 2B).

Next, the adhesive composition is applied onto the release agent layer 2 to form an adhesive coating layer 3a (Fig. 2C).

Next, the support substrate 4 is disposed on the adhesive coating layer 3a (Fig. 2D).

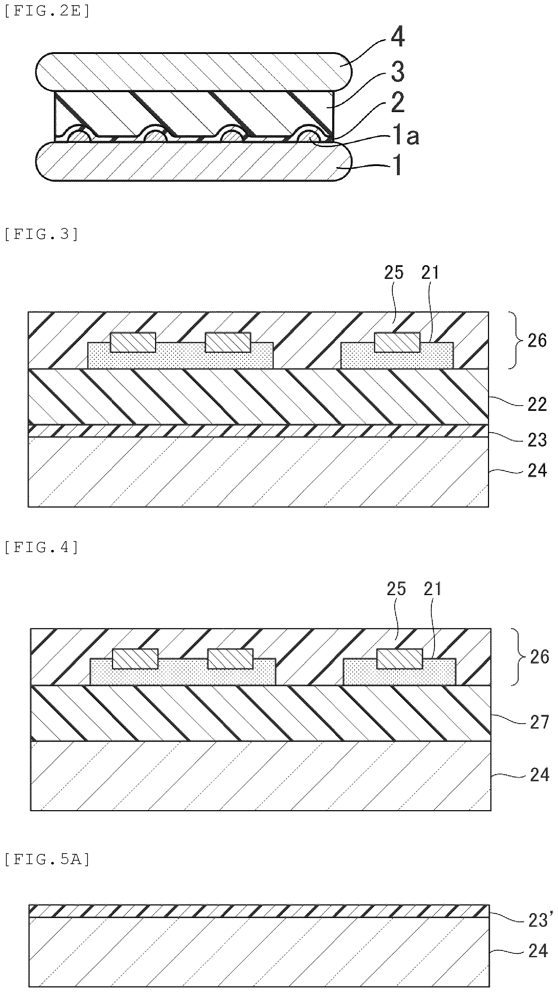

Next, after a load is applied in the thickness direction between the semiconductor substrate 1 and the support substrate 4 under reduced pressure, a heating apparatus (not illustrated; a hot plate) is disposed on the surface opposite to the surface of the semiconductor substrate 1 on which the bump 1a is present, and the adhesive coating layer 3a is heated and cured by the heating apparatus to be converted into the adhesive layer 3 (Fig. 2E).

A laminate is obtained by the steps shown in Figs. 2A to 2E.

Note that, in Fig. 1, since the semiconductor substrate 1, the release agent layer 2, the adhesive layer 3, and the support substrate 4 are stacked in this order in the laminate, the above-described production method has been described as an example. For example, in the case of producing a laminate in which the semiconductor substrate 1, the adhesive layer 3, the release agent layer 2, and the support substrate 4 are laminated in this order, the production can be performed by a method including Step 1 of forming an adhesive coating layer by coating the surface of the semiconductor substrate with the an adhesive composition and, if necessary, heating the adhesive composition, Step 2 of forming a release agent layer by coating the surface of the support substrate with a release agent composition and, if necessary, heating the release agent composition, and Step 3 of obtaining a laminate by applying a load in the thickness direction of the semiconductor substrate and the support substrate to bring the semiconductor substrate and the support substrate into close contact with each other while performing at least one of the heat treatment and the pressure reduction treatment, then performing a post-heat treatment.

As long as the effect of the present invention is not impaired, application and heating of each composition may be sequentially performed on any one of the substrates.

### <Second Embodiment>

The laminate having the electronic device layer is used for processing the electronic device layer. While the electronic device layer is being processed, the electronic device layer is adhered to the support substrate. After processing the electronic device layer, the release agent layer is irradiated with light, and then the electronic device layer is separated from the support substrate.

### <<Electronic Device Layer>>

The electronic device layer refers to a layer having an electronic device, and in the present invention, refers to a layer in which a plurality of semiconductor chip substrates are embedded in a sealing resin, that is, a layer including a plurality of semiconductor chip substrates and a sealing resin disposed between the semiconductor chip substrates.

Here, the "electronic device" means a member constituting at least a part of the electronic component. The electronic device is not particularly limited, and various mechanical structures and circuits may be formed on the surface of the semiconductor substrate. The electronic device is preferably a composite of a member made of metal or a semiconductor and a resin that seals or insulates the member. The electronic device may be one in which a rewiring layer, which will be described later, and/or a semiconductor element or other elements are sealed or insulated with a sealing material or an insulating material, and has a single-layer or multi-layer structure.

### <<Support Substrate>>

As the support substrate, those similar to those described in the section of <<Support substrate>> above of <First embodiment> above are exemplified.

### <<Release Agent Layer>>

The release agent layer is formed using the release agent composition for photoirradiation release of the present invention described above.

The detailed description of the release agent layer is as described in the section of <<Release Agent Layer>> of <First Embodiment> above.

### <<Adhesive Layer>>

The adhesive layer is formed using the adhesive composition described above.

The detailed description of the adhesive layer is as described in the section of <<Adhesive Layer>> above of <First Embodiment> above.

Hereinafter, an example of the configuration of the laminate of the second embodiment will be described with reference to the drawings.

Fig. 3 shows a schematic cross-sectional view of an example of a laminate of the second embodiment.

The laminate of Fig. 3 includes a support substrate 24, a release agent layer 23, an adhesive layer 22, and an electronic device layer 26 in this order.

The electronic device layer 26 includes a plurality of semiconductor chip substrates 21 and a sealing resin 25 which is a sealing material disposed between the semiconductor chip substrates 21.

The adhesive layer 22 and the release agent layer 23 are provided between the electronic device layer 26 and the support substrate 24. The adhesive layer 22 is in contact with the electronic device layer 26. The release agent layer 23 is in contact with the adhesive layer 22 and the support substrate 24.

Further, another example of the configuration of the laminate of the second embodiment is shown in Fig. 4.

When the release agent layer according to the present invention is a release agent layer having both a release function and an adhesive function and having adhesive performance, the laminate may be formed not in a two-layer structure of the release agent layer and the adhesive layer but in a one-layer structure of the release agent layer having adhesive performance.

Fig. 4 is a schematic cross-sectional view of another example of the laminate.

The laminate of Fig. 4 includes the support substrate 24, a release agent layer 27 having adhesive performance, and the electronic device layer 26 in this order.

The release agent layer 27 having adhesive performance is provided between the support substrate 24 and the electronic device layer 26. The release agent layer 27 having adhesive performance can be produced by mixing constituents of a release agent composition for forming a release agent with constituents of an adhesive composition for forming an adhesive layer.

### <<Method for Producing One Example of Laminate in Second Embodiment>>

A method for producing a laminate will be described below with the laminate shown in Fig. 3 as an example of the laminate in the second embodiment.

The laminate of the present invention can be produced, for example, by a method including the following Steps 1 to 5.

Step 1: a step of forming a release agent coating layer by coating the surface of the support substrate with a release agent composition (if necessary, further heating is performed to form a release agent layer.)

Step 2: a step of forming an adhesive coating layer by coating the surface of the release agent coating layer or the release agent layer with an adhesive composition (if necessary, further heating is performed to form an adhesive layer.)

Step 3: a step of placing the semiconductor chip substrate on the adhesive coating layer or the adhesive layer, and bonding the semiconductor chip substrate to the adhesive coating layer or the adhesive layer while performing at least one of the heat treatment and the pressure reduction treatment

Step 4: step of forming an adhesive layer by curing the adhesive coating layer by post-heat treatment

Step 5: step of sealing the semiconductor chip substrate fixed onto the adhesive layer using a sealing resin

Step 3 will be described in more detail, for example, in the following step (i) of the embodiment.
(i) The semiconductor chip substrate is placed on the adhesive coating layer or the adhesive layer, and while at least one of the heat treatment and the pressure reduction treatment is performed, a load is applied in the thickness direction of the semiconductor chip substrate and the support substrate to bring the semiconductor chip substrate and the support substrate into close contact with each other, and the semiconductor chip substrate is bonded to the adhesive coating layer or the adhesive layer.

Furthermore, Step 4 may be performed after the semiconductor chip substrate in Step 3 is bonded to the adhesive coating layer, or may be performed in combination with Step 3. For example, by placing the semiconductor chip substrate on the adhesive coating layer and heating and curing the adhesive coating layer while applying a load in the thickness direction of the semiconductor chip substrate and the support substrate, adhesion between the semiconductor chip substrate and the adhesive coating layer and curing from the adhesive coating layer to the adhesive layer may be performed together, and the adhesive layer and the semiconductor chip substrate may be bonded to each other.

In addition, Step 4 may be performed before Step 3, the semiconductor chip substrate may be placed on the adhesive layer, and while a load is applied in the thickness direction of the semiconductor chip substrate and the support substrate, the adhesive layer and the semiconductor chip substrate may be bonded to each other.

The coating method, the heating temperature of the coated release agent composition or adhesive composition, the heating means, and the like are as described in <<Method for Producing One Example of Laminate in First Embodiment>> above of <First embodiment> above.

Hereinafter, the procedure of the method for producing a laminate of the second embodiment will be described in more detail with reference to the drawings. In this production method, the laminate shown in Fig. 3 is produced.

As shown in Fig. 5A, a release agent coating layer 23' made of a release agent composition is formed on the support substrate 24. At that time, the release agent coating layer 23' may be heated to form the release agent layer 23.

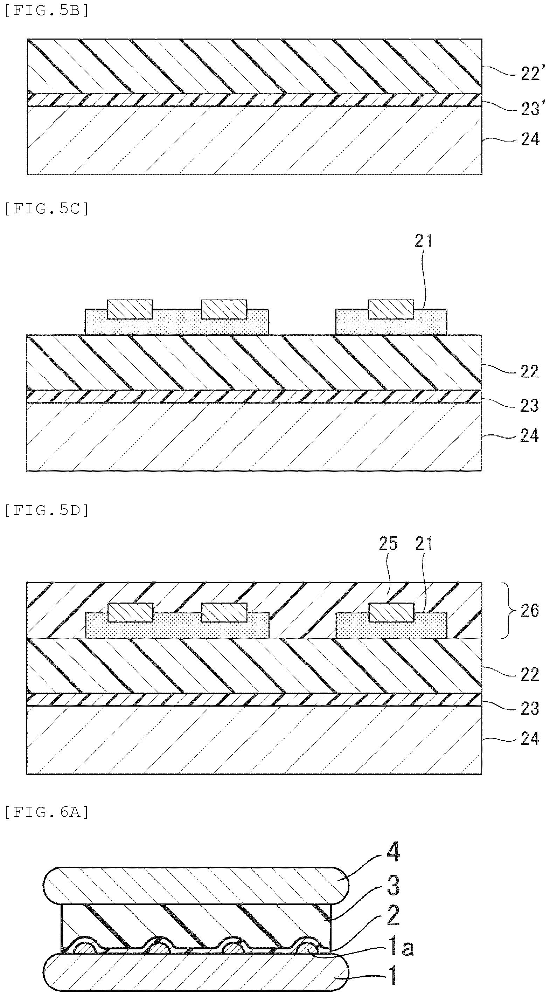

Next, as shown in Fig. 5B, an adhesive coating layer 22' made of an adhesive composition is formed on the release agent coating layer 23' or the release agent layer 23. At that time, the adhesive coating layer 22' may be heated to form the adhesive layer 22.

Next, as shown in Fig. 5C, the semiconductor chip substrate 21 is placed on the adhesive layer 22 or the adhesive coating layer 22', and while at least one of the heat treatment and the pressure reduction treatment is performed, a load is applied in the thickness direction of the semiconductor chip substrate 21 and the support substrate 24 to bring the semiconductor chip substrate 21 and the support substrate 24 into close contact with each other, and the semiconductor chip substrate 21 is bonded to the adhesive layer 22 or the adhesive coating layer 22'. When the semiconductor chip substrate 21 is bonded to the adhesive coating layer 22', the adhesive coating layer 22' is cured by post-heat treatment to form the adhesive layer 22, and the semiconductor chip substrate 21 is fixed to the adhesive layer 22.

Furthermore, when the adhesive coating layer 22' is subjected to the post-heat treatment, the release agent coating layer 23' may also be subjected to the post-heat treatment to form the release agent layer 23.

Next, as illustrated in Fig. 5D, the semiconductor chip substrate 21 fixed onto the adhesive layer 22 is sealed using the sealing resin 25. In Fig. 5D, the plurality of semiconductor chip substrates 21 temporarily adhered onto the support substrate 24 via the adhesive layer 22 is sealed with the sealing resin 25. The electronic device layer 26, which includes the semiconductor chip substrate 21 and the sealing resin 25 disposed in the semiconductor chip substrate 21, is formed on the adhesive layer 22, and as described above, the electronic device layer 26 is a base material layer in which a plurality of semiconductor chip substrates are embedded in the sealing resin.

### <<<Sealing Step>>>

The semiconductor chip substrate 21 is sealed using a sealing material.

As a sealing material for sealing the semiconductor chip substrate 21, a member capable of insulating or sealing a member made of metal or a semiconductor is used.

In the present invention, for example, a resin composition (sealing resin) is used as the sealing material. The type of the sealing resin is not particularly limited as long as it is possible to seal and/or insulate a metal or a semiconductor, but for example, an epoxy-based resin or a silicone-based resin is preferably used.

The sealing material may contain other components such as a filler in addition to the resin component. Examples of the filler include spherical silica particles.

In the sealing step, for example, a sealing resin heated to 130 to 170°C is supplied onto the adhesive layer 22 to cover the semiconductor chip substrate 21 while maintaining a high viscosity state, and is compression-molded to form a layer including the sealing resin 25 on the adhesive layer 22. At this time, the temperature condition is, for example, 130 to 170°C. In addition, the pressure applied to the semiconductor chip substrate 21 is, for example, 50 to 500 N/cm².

### (Method for Producing Processed Semiconductor Substrate or Electronic Device Layer)

When the laminate according to the present invention is used, a method for producing a processed semiconductor substrate or a method for producing a processed electronic device layer can be provided.

In the "method for producing a processed semiconductor substrate", the laminate described in the section of <First embodiment> above in (Laminate) above is used. In addition, in the "method for producing a processed electronic device layer", the laminate described in the section of <Second Embodiment> above of the (Laminate) above is used.

The "method for producing a processed semiconductor substrate" will be described in the following <Third Embodiment>, and the "method for producing a processed electronic device layer" will be described in the following

### <Fourth Embodiment>.

### <Third Embodiment>

The method for producing a processed semiconductor substrate according to the present invention includes the following Step 5A and the following Step 6A. The method for producing the processed electronic device layer may further include the following Step 7A.

Here, Step 5A is a step of processing the semiconductor substrate in the laminate described in the section of <First Embodiment> above.

In addition, Step 6A is a step of separating the processed semiconductor substrate and the support substrate in Step 5A.

Further, Step 7A is a step of cleaning the processed semiconductor substrate after Step 6A.

The processing performed on the semiconductor substrate in Step 5A is, for example, processing on the side opposite to the circuit surface of the wafer, and includes thinning of the wafer by polishing the back surface of the wafer. Thereafter, for example, a through silicon via (TSV) or the like is formed, and then the thinned wafer is released from the support substrate to form a laminate of wafers, and the wafer is three-dimensionally mounted. In addition, for example, a wafer back surface electrode and the like are also formed before and after that. Heat of approximately 250 to 350°C is applied to thinning of a wafer and a TSV process in a state of being adhered to a support substrate. The laminate of the present invention usually has heat resistance to the load including the adhesive layer.

Note that the processing is not limited to the above-described processing, and includes, for example, implementation of a process of mounting a semiconductor component in a case where the semiconductor component is temporarily adhered to a support substrate in order to support a base material for mounting the semiconductor component.

In Step 6A, examples of the method for separating (releasing) the semiconductor substrate and the support substrate include a method for mechanical releasing with equipment having a sharp part, a releasing method for separation between the support and the semiconductor wafer, and the like after the photoirradiation to the release agent layer, but are not limited thereto.

By irradiating the release agent layer with light from the support substrate side, the properties of the release agent layer are changed (for example, separation or decomposition of the release agent layer) as described above, and thereafter, for example, one of the substrates is pulled up, and the semiconductor substrate and the support substrate can be easily separated from each other.

The release agent layer is not necessarily irradiated with light over the entire region of the release agent layer. Even when the region irradiated with light and the region not irradiated with light are mixed, the semiconductor substrate and the support substrate can be separated from each other by a slight external force such as pulling up of the support substrate as long as the release agent layer as a whole has sufficiently improved releasing ability. The ratio and positional relationship between the region irradiated with light and the region not irradiated with light vary depending on the type and specific composition of the adhesive to be used, the thickness of the adhesive layer, the thickness of the adhesive layer, the thickness of the release agent layer, the intensity of light to be irradiated, and the like, but those skilled in the art can appropriately set conditions without requiring an excessive test. For such circumstances, according to the method for producing a processed semiconductor substrate of the present invention, for example, in a case where the support substrate of the laminate to be used is light-transmissive, it is possible to shorten the photoirradiation time when releasing is performed by photoirradiation from the support substrate side, and as a result, not only improvement in throughput can be expected, but also physical stress and the like required for releasing can be avoided, and the semiconductor substrate and the support substrate can be easily and efficiently separated from each other only by photoirradiation.

Usually, the irradiation amount of light for release is 50 to 3,000 mJ/cm². The irradiation time is appropriately determined according to the wavelength and the irradiation amount.

As described above, the wavelength of light used for release is preferably, for example, a wavelength of 250 to 600 nm, and more preferably a wavelength of 250 to 370 nm. A more suitable wavelength is 308 nm, 343 nm, 355 nm, 365 nm, or 532 nm. The irradiation amount of light required for release is an irradiation amount that can cause suitable change in properties, for example, decomposition of the Novolac resin.

The light used for release may be laser light or non-laser light emitted from a light source such as an ultraviolet lamp.

The substrate can be cleaned by spraying the cleaning agent composition onto the surface of at least one of the separated semiconductor substrate and the support substrate, or immersing the separated semiconductor substrate or the support substrate in the cleaning agent composition.

In addition, the surface of the processed semiconductor substrate or the like may be cleaned using a removal tape or the like.

As an example of cleaning the substrate, Step 7A of cleaning the processed semiconductor substrate may be performed after Step 6A.

Examples of the cleaning agent composition to be used for cleaning include the following.

The cleaning agent composition usually contains a salt and a solvent.

A suitable example of the cleaning agent composition includes a cleaning agent composition containing a quaternary ammonium salt and a solvent.

The quaternary ammonium salt is composed of a quaternary ammonium cation and an anion, and is not particularly limited as long as the quaternary ammonium salt is used for this type of application.

Such quaternary ammonium cations typically include tetra (hydrocarbon) ammonium cations. On the other hand, as an anion paired therewith, a hydroxide ion (OH⁻); halogen ions such as a fluorine ion (F⁻), a chlorine ion (Cl⁻), a bromine ion (Br⁻), and an iodine ion (I⁻); tetrafluoroborate ion (BF₄⁻); hexafluorophosphate ions (PF₆⁻) and the like, but are not limited thereto.

The quaternary ammonium salt is preferably a halogen-containing quaternary ammonium salt, and more preferably a fluorine-containing quaternary ammonium salt.

In the quaternary ammonium salt, the halogen atom may be contained in the cation or the anion, but is preferably contained in the anion.

In a preferred aspect, the fluorine-containing quaternary ammonium salt is tetra(hydrocarbon)ammonium fluoride.

Specific examples of the hydrocarbon group in tetra(hydrocarbon)ammonium fluoride include an alkyl group having 1 to 20 carbon atoms, an alkenyl group having 2 to 20 carbon atoms, an alkynyl group having 2 to 20 carbon atoms, and an aryl group having 6 to 20 carbon atoms.

In a more preferred aspect, the tetra(hydrocarbon)ammonium fluoride contains tetraalkylammonium fluoride.

Specific examples of tetraalkylammonium fluoride include tetramethylammonium fluoride, tetraethylammonium fluoride, tetrapropylammonium fluoride, and tetrabutylammonium fluoride (also referred to as tetrabutylammonium fluoride), but are not limited to. Among them, tetrabutylammonium fluoride is preferable.

As the quaternary ammonium salt such as tetra(hydrocarbon)ammonium fluoride, a hydrate may be used. In addition, the quaternary ammonium salts such as tetra(hydrocarbon)ammonium fluoride may be used alone or in combination of two or more thereof.

The amount of the quaternary ammonium salt is not particularly limited as long as the quaternary ammonium salt dissolves in the solvent contained in the cleaning agent composition, but is usually 0.1 to 30% by mass with respect to the cleaning agent composition.

The solvent contained in the cleaning agent composition is not particularly limited as long as the solvent is used for this type of application and dissolves a salt such as a quaternary ammonium salt, but from the viewpoint of obtaining a cleaning agent composition having excellent cleanability with good reproducibility, the viewpoint of obtaining a cleaning agent composition having excellent uniformity by dissolving a salt such as a quaternary ammonium salt satisfactorily, and the like, the cleaning agent composition preferably contains one or more amide-based solvents.

Suitable examples of the amide-based solvent include an acid amide derivative represented by Formula (Z).

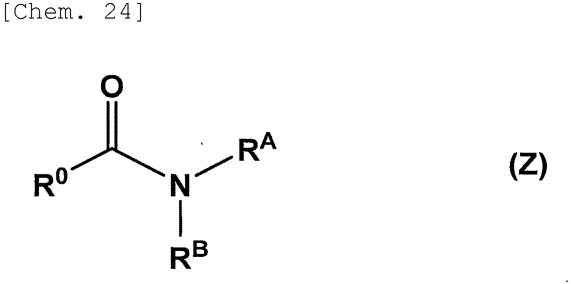

In the formula, R⁰ represents an ethyl group, a propyl group or an isopropyl group, and is preferably an ethyl group or an isopropyl group, and more preferably an ethyl group. R^{A} and R^{B} each independently represent an alkyl group having 1 to 4 carbon atoms. The alkyl group having 1 to 4 carbon atoms may be linear, branched, or cyclic, and specific examples thereof include a methyl group, an ethyl group, a propyl group, an isopropyl group, a cyclopropyl group, an n-butyl group, an isobutyl group, an s-butyl group, a t-butyl group, and a cyclobutyl group. Among them, R^{A} and R^{B} are preferably a methyl group or an ethyl group, more preferably a methyl group or an ethyl group, and still more preferably a methyl group.

Examples of the acid amide derivative represented by Formula (Z) include N,N-dimethylpropionamide, N,N-diethylpropionamide, N-ethyl-N-methylpropionamide, N,N-dimethylbutyramide, N,N-diethylbutyramide, N-ethyl-N-methylbutyramide, N,N-dimethylisobutyramide, N,N-diethylisobutyramide, and N-ethyl-N-methylisobutyramide. Among them, N,N-dimethylpropionamide and N,N-dimethylisobutyramide are particularly preferable, and N,N-dimethylpropionamide is more preferable.

The acid amide derivative represented by Formula (Z) may be synthesized by a substitution reaction between a corresponding carboxylic acid ester and an amine, or a commercially available product may be used.

Another example of the preferred amide-based solvent is a lactam compound represented by Formula (Y).

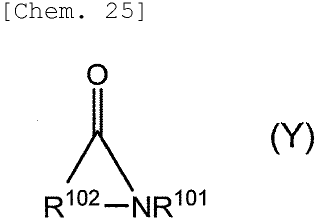

In Formula (Y), R¹⁰¹ represents a hydrogen atom or an alkyl group having 1 to 6 carbon atoms, and R¹⁰² represents an alkylene group having 1 to 6 carbon atoms. Specific examples of the alkyl group having 1 to 6 carbon atoms include a methyl group, an ethyl group, an n-propyl group, and an n-butyl group, and specific examples of the alkylene group having 1 to 6 carbon atoms include a methylene group, an ethylene group, a trimethylene group, a tetramethylene group, a pentamethylene group, and a hexamethylene group, but are not limited thereto.

Specific examples of the lactam compound represented by Formula (Y) include an α-lactam compound, a β-lactam compound, a γ-lactam compound, and a δ-lactam compound, and these compounds can be used alone or in combination of two or more thereof.

In a preferred aspect, the lactam compound represented by Formula (Y) contains 1-alkyl-2 pyrrolidone (N-alkyl-γ-butyrolactam), in a more preferred aspect, N-methylpyrrolidone (NMP) or N-ethylpyrrolidone (NEP), and in a still more preferred aspect, N-methylpyrrolidone (NMP).

The cleaning agent composition may contain one or more other organic solvents different from the above-described amide compound.

Such other organic solvents are used for this type of application, and are not particularly limited as long as the other organic solvents are organic solvents compatible with the above-described amide compound.

Examples of other preferred solvents include alkylene glycol dialkyl ethers, aromatic hydrocarbon compounds, and cyclic structure-containing ether compounds, but are not limited thereto.

The amount of the other organic solvent different from the above-described amide compound is usually appropriately determined to be 95% by mass or less in the solvent contained in the cleaning agent composition as long as the quaternary ammonium salt contained in the cleaning agent composition is not precipitated or separated, and is uniformly mixed with the above-described amide compound.

In addition, the cleaning agent composition may contain water as the solvent, but usually, only an organic solvent is intended to be used as the solvent from the viewpoint of avoiding corrosion of the substrate and the like. In this case, it is not denied that hydrated water of the salt or trace amounts of water contained in the organic solvent is contained in the cleaning agent composition. The water content of the cleaning agent composition is usually 5% by mass or less.

The constituent elements and method elements related to the above-described steps of the method for producing a processed semiconductor substrate of the present invention may be variously changed without departing from the gist of the present invention.

The method for producing a processed semiconductor substrate of the present invention may include steps other than the above-described steps.

In the releasing method for the present invention, when the semiconductor substrate or the support substrate of the laminate of the present invention is light-transmissive, the semiconductor substrate and the support substrate of the laminate are separated from each other by irradiating the release agent layer with light from the semiconductor substrate side or the support substrate side.

In an example of the laminate of the present invention, since the semiconductor substrate and the support substrate are temporarily adhered to each other by the adhesive layer and the release agent layer to be suitably releasable, for example, when the support substrate is light-transmissive, the semiconductor substrate and the support substrate can be easily separated from each other by irradiating the release agent layer with light from the support substrate side of the laminate. Usually, releasing is performed after the semiconductor substrate of the laminate is processed.

An example of the third embodiment will be described with reference to Figs. 6A to 6C. This example is an example of producing a thinned semiconductor substrate.

First, a laminate is prepared (Fig. 6A). This laminate is the same laminate as the laminate shown in Figs. 1 and 2E.

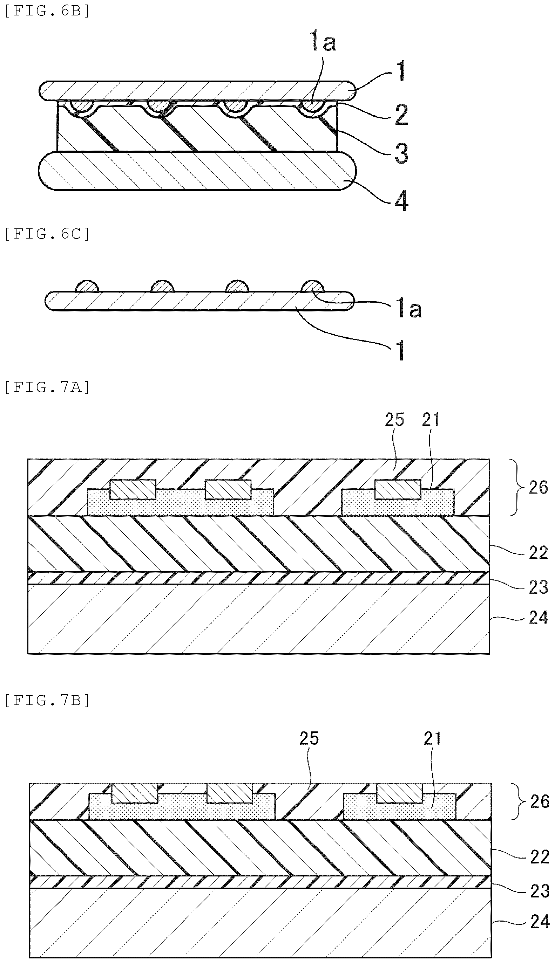

Next, the surface of the semiconductor substrate 1 opposite to the surface on which the bumps 1a is present is polished using a polishing apparatus (not illustrated) to thin the semiconductor substrate 1 (Fig. 6B). A through electrode may be formed on the thinned semiconductor substrate 1.

Next, after the release agent layer 2 is irradiated with light from the support substrate 4 side, the thinned semiconductor substrate 1 and the support substrate 4 are released using a releasing apparatus (not illustrated). Then, the thinned semiconductor substrate 1 is obtained (Fig. 6C).

Here, residues of the release agent layer 2 and the adhesive layer 3 may remain on the thinned semiconductor substrate 1. Therefore, it is preferable to clean the thinned semiconductor substrate 1 using the cleaning agent composition to remove the residues of the release agent layer 2 and the adhesive layer 3 from the semiconductor substrate 1.

### <Fourth Embodiment>

The method for producing a processed electronic device layer of the present invention includes the following Step 5B and the following Step 6B. The method for producing the processed electronic device layer may further include the following Step 7B.

Here, Step 5B is a step of processing the electronic device layer in the laminate described in the section of

### <Second Embodiment>.

In addition, Step 6B is a step of separating the electronic device layer processed in Step 5B from the support substrate.

In addition, Step 7B is a step of cleaning the processed electronic device layer after the Step 6B.

Hereinafter, a specific example of the fourth embodiment will be described with reference to Figs. 7A to 7F.

Examples of the processing performed on the electronic device layer in Step 5B include a grinding step and a wiring layer forming step.

### <<Grinding Step>>

The grinding step is a step of grinding the resin part of the layer of the sealing resin 25 in the electronic device layer 26 such that a part of the semiconductor chip substrate 21 is exposed.

For example, as illustrated in Fig. 7B, the sealing resin part is ground by grinding the layer of the sealing resin 25 of the laminate illustrated in Fig. 7A until the layer has a thickness substantially equal to that of the semiconductor chip substrate 21. In addition, the laminate shown in Fig. 7A is the same laminate as the laminate shown in Figs. 3 and 5D.

### <<Wiring Layer Forming Step>>

The wiring layer forming step is a step of forming a wiring layer on the exposed semiconductor chip substrate 21 after the grinding step.

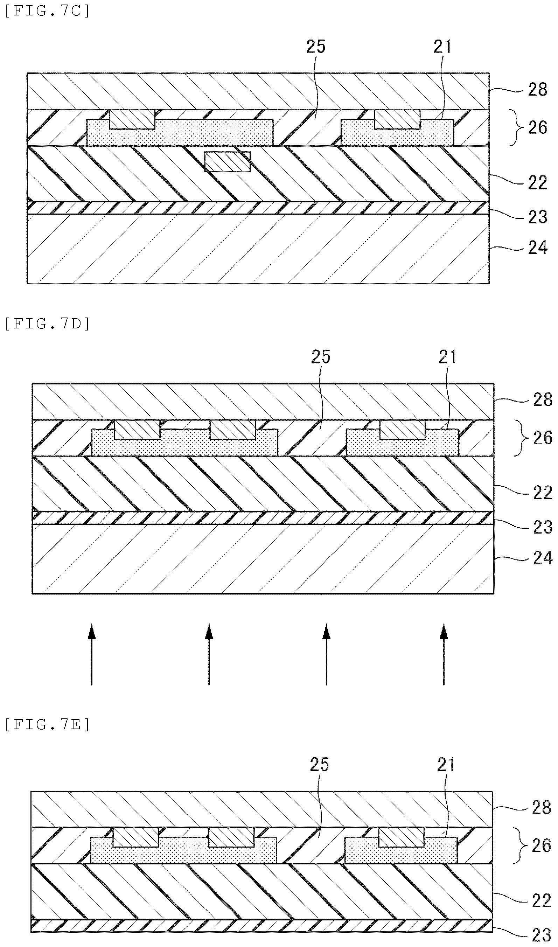

In Fig. 7C, a wiring layer 28 is formed on the electronic device layer 26 including the semiconductor chip substrate 21 and a layer of the sealing resin 25.

The wiring layer 28 is also called a redistribution layer (RDL), is a thin-film wiring body constituting wiring connected to a substrate, and may have a single-layer or multi-layer structure. The wiring layer may be one in which wiring is formed by a conductor (for example, metals such as aluminum, copper, titanium, nickel, gold, and silver, and alloys such as silver-tin alloys) between dielectrics (photosensitive resin such as silicon oxide (SiOₓ) and photosensitive epoxy), but is not limited thereto.

Examples of the method for forming the wiring layer 28 include the following methods.

First, a dielectric layer of silicon oxide (SiOₓ), a photosensitive resin, or the like is formed on the layer of the sealing resin 25. The dielectric layer made of silicon oxide can be formed by, for example, a sputtering method, a vacuum vapor deposition method, or the like. The dielectric layer made of a photosensitive resin can be formed by coating the layer of the sealing resin 25 with a photosensitive resin by a method such as spin coating, dipping, roller blade, spray coating, or slit coating.

Subsequently, wiring is formed on the dielectric layer with a conductor such as metal. As a method for forming the wiring, for example, a known semiconductor process method such as lithography processing such as photolithography (registry lithography) or etching processing can be used. Examples of such lithography processing include lithography processing using a positive resist material and lithography processing using a negative resist material.

In the method for producing a laminate according to the fourth embodiment, a bump can be further formed on the wiring layer 28 or an element can be mounted. The element can be mounted on the wiring layer 28 using, for example, a chip mounter or the like.

The laminate according to the fourth embodiment may be a laminate produced in a process based on a fan-out type technology in which a terminal provided on a semiconductor chip substrate is mounted on a wiring layer extending outside a chip area.

In Step 6B, examples of the method for separating (releasing) the electronic device layer and the support substrate include a method for mechanical releasing with equipment having a sharp part, a releasing method for separation between the support and the electronic device layer, and the like after the photoirradiation to the release agent layer, but are not limited thereto.

By irradiating the release agent layer with light from the support substrate side, the properties of the release agent layer are changed (for example, separation or decomposition of the release agent layer) as described above, and thereafter, for example, one of the substrates is pulled up, and the electronic device layer and the support substrate can be easily separated from each other.

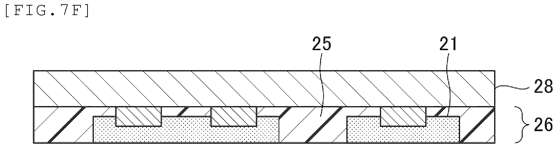

Figs. 7D to 7E are schematic cross-sectional views for explaining a separation method for the laminate, and Fig. 7F is a schematic cross-sectional view for explaining a cleaning method after separation of the laminate. One embodiment of the method for producing a semiconductor package (electronic component) can be described with reference to Figs. 7D to 7F.

As shown in Fig. 7D, the step of separating the laminate is a step of separating the electronic device layer 26 and the support substrate 24 from each other by irradiating the release agent layer 23 with light (arrow) through the support substrate 24 to change the properties of the release agent layer 23.

After irradiating the release agent layer 23 with light (arrow) to change the properties of the release agent layer 23, the support substrate 24 is separated from the electronic device layer 26 as shown in Fig. 7E.

The irradiation conditions, irradiation methods, and the like of photoirradiation to the adhesive layer are as described in the section of <Third Embodiment> above.

The substrate can be cleaned by spraying the cleaning agent composition onto the surface of at least one of the separated electronic device layer and the support substrate, or immersing the separated electronic device layer or the support substrate in the cleaning agent composition.

In addition, the surface of the processed electronic device layer or the like may be cleaned using a removal tape or the like.

For example, in Fig. 7E, the adhesive layer 22 and the release agent layer 23 are attached to the electronic device layer 26 after the separation step, but the adhesive layer 22 and the release agent layer 23 can be removed by decomposing the adhesive layer 22 and the release agent layer 23 using a cleaning agent composition such as acid or alkali. By removing the release agent layer and the adhesive layer, a processed electronic device layer (electronic component) as shown in Fig. 7F can be suitably obtained.

The constituent elements and method elements related to the above-described steps of the method for producing a processed electronic device layer of the present invention may be variously changed without departing from the gist of the present invention.

The method for producing a processed electronic device layer of the present invention may include steps other than the steps described above.

In the laminate of the present invention, since the electronic device layer and the support substrate are temporarily adhered to each other by the adhesive layer to be suitably releasable, for example, when the support substrate is light-transmissive, the electronic device layer and the support substrate can be easily separated from each other by irradiating the release agent layer with light from the support substrate side of the laminate. Usually, releasing is performed after the electronic device layer of the laminate is processed.

### Examples

Hereinafter, the present invention will be more specifically described with reference to examples, but the present invention is not limited to the following examples. In addition, the apparatus used is as follows.

### [Apparatus]

(1) Stirrer A: planetary centrifugal mixer ARE-500 manufactured by Thinky Corporation
(2) Stirrer H: warming-type rocking mixer HRM-1 manufactured by AS ONE Corporation
(3) Viscometer: rotation viscometer TVE-22H manufactured by Toki Sangyo Co., Ltd.
(4) Optical film thickness meter (film thickness measurement): F-50 manufactured by Filmetrics Corporation
(5) Vacuum bonding apparatus: manual bonder manufactured by SUSS MicroTec
(6) Measurement of weight average molecular weight and dispersibility:
   GPC apparatus (EcoSEC, HLC-8320GPC manufactured by Tosoh Corporation) and GPC column (TSKgel SuperMultiporeHZ-N and TSKgel SuperMultiporeHZ-H manufactured by Tosoh Corporation)
   · Column temperature: 40°C
   · Eluent (elution solvent): tetrahydrofuran
   · Flow rate: 0.35 mL/min
   · Standard sample: polystyrene (manufactured by Sigma-Aldrich)
(7) Laser irradiation apparatus: Lambda SX manufactured by Coherent, Inc.

### [1] Synthesis of polymer contained in release agent layer

### [Synthesis Example 1-1]

Under nitrogen, 15.0 g of carbazole (manufactured by Tokyo Chemical Industry Co., Ltd.), 11.88 g of 2-ethylhexylaldehyde (manufactured by Tokyo Chemical Industry Co., Ltd.), and 0.90 g of methanesulfonic acid (manufactured by Tokyo Chemical Industry Co., Ltd.) were added in a 200 mL four-necked flask, and 64.33 g of propylene glycol monomethyl ether acetate (manufactured by KANTO CHEMICAL CO., INC., hereinafter abbreviated as PGMEA) was further added thereto. The mixture was stirred, heated to 150°C, and dissolved to initiate polymerization. After 24 hours, the mixture was allowed to cool to room temperature, and then reprecipitated in 300 g of methanol:water (7:3 (mass ratio)). The obtained precipitate was separated by decantation and dried in a vacuum dryer at 60°C for 24 hours to obtain a target polymer (hereinafter abbreviated as PCzEHA).

The weight average molecular weight Mw of PCzEHA measured in terms of polystyrene by GPC was 1,800. The obtained polymer was dissolved in PGMEA, and ion exchange was performed using a cation exchange resin and an anion exchange resin for 4 hours to obtain a target polymer solution.

PCzEHA has the following repeating units.

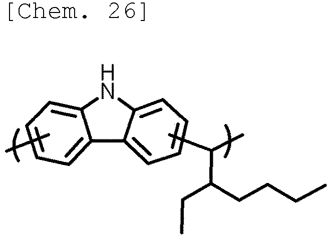

### [Synthesis Example 1-2]

Under nitrogen, 15.03 g of carbazole (manufactured by Tokyo Chemical Industry Co., Ltd.), 9.51 g of benzaldehyde (manufactured by Tokyo Chemical Industry Co., Ltd.), and 0.44 g of methanesulfonic acid (manufactured by Tokyo Chemical Industry Co., Ltd.) were added in a 200 mL four-necked flask, and 58.24 g of PGMEA (manufactured by KANTO CHEMICAL CO., INC.) was further added thereto. The mixture was stirred, and heated to 120°C for dissolution to initiate polymerization. After 3 hours, the mixture was allowed to cool to room temperature, and then reprecipitated in 300 g of methanol:water (7:3 (mass ratio)). The obtained precipitate was filtered, and dried in a vacuum dryer at 60°C for 24 hours to obtain a target polymer (hereinafter abbreviated as PCzBA).

The weight average molecular weight Mw of PCzBA measured in terms of polystyrene by GPC was 3,200. The obtained polymer was dissolved in PGMEA, and ion exchange was performed using a cation exchange resin and an anion exchange resin for 4 hours to obtain a target polymer solution.

PCzBA has the following repeating units.

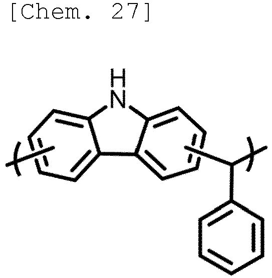

### [Synthesis Example 1-3]

Under nitrogen, 8.00 g of carbazole (manufactured by Tokyo Chemical Industry Co., Ltd.), 7.55 g of 1-naphthaldehyde (manufactured by Tokyo Chemical Industry Co., Ltd.), and 0.95 g of p-toluenesulfonic acid monohydrate (manufactured by KANTO CHEMICAL CO., INC.) were added in a 100 mL four-necked flask, and 8 g of 1,4-dioxane (manufactured by KANTO CHEMICAL CO., INC.) was further added thereto. The mixture was stirred, and heated to 100°C for dissolution to initiate polymerization. After 4 hours, the mixture was allowed to cool to 60°C, and then diluted by adding 40 g of chloroform (manufactured by KANTO CHEMICAL CO., INC.), and reprecipitated in 200 g of methanol. The obtained precipitate was filtered, and dried in a vacuum dryer at 60°C for 10 hours, and further at 120°C for 24 hours to obtain a target polymer (hereinafter abbreviated as PCzNA).

The weight average molecular weight Mw of PCzNA measured in terms of polystyrene by GPC was 2,600. The obtained polymer was dissolved in PGMEA, and ion exchange was performed using a cation exchange resin and an anion exchange resin for 4 hours to obtain a target polymer solution.

PCzNA has the following repeating units.

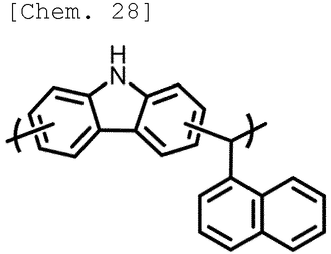

### [Synthesis Example 1-4]

Under nitrogen, 8.00 g of carbazole (manufactured by Tokyo Chemical Industry Co., Ltd.), 8.63 g of 9-fluorenone (manufactured by Tokyo Chemical Industry Co., Ltd.), and 2.3 g of methanesulfonic acid (manufactured by Tokyo Chemical Industry Co., Ltd.) were added in a 200 mL four-necked flask, and 18.93 g of PGMEA (manufactured by KANTO CHEMICAL CO., INC.) was further added thereto. The mixture was stirred, heated to 150°C, and dissolved to initiate polymerization. After 1.5 hours, the mixture was allowed to cool to room temperature, and then reprecipitated in 300 g of methanol:water (7:3 (mass ratio)). The obtained precipitate was filtered, and dried in a vacuum dryer at 60°C for 24 hours to obtain a target polymer (hereinafter abbreviated as PCzFL).

The weight average molecular weight Mw of PCzFL measured in terms of polystyrene by GPC was 2,600. The obtained polymer was dissolved in PGMEA, and ion exchange was performed using a cation exchange resin and an anion exchange resin for 4 hours to obtain a target polymer solution.

PCzFL has the following repeating units.

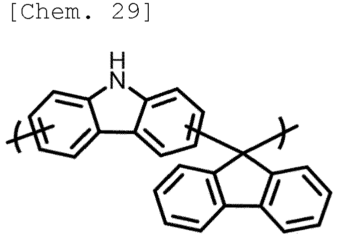

### [Synthesis Example 1-5]

Under nitrogen, 9.99 g of diphenylamine (manufactured by Tokyo Chemical Industry Co., Ltd.), 7.52 g of 2-ethylhexylaldehyde (manufactured by Tokyo Chemical Industry Co., Ltd.), and 0.86 g of methanesulfonic acid (manufactured by Tokyo Chemical Industry Co., Ltd.) were added in a 200 mL four-necked flask, and 42.88 g of PGMEA (manufactured by KANTO CHEMICAL CO., INC.) was further added thereto. The mixture was stirred, heated to 150°C, and dissolved to initiate polymerization. After 24 hours, the mixture was allowed to cool to room temperature, and then reprecipitated in 300 g of methanol:water (7:3 (mass ratio)). The obtained precipitate was separated by decantation and dried in a vacuum dryer at 60°C for 24 hours to obtain a target polymer (hereinafter abbreviated as DPAEHA).

The weight average molecular weight Mw of DPAEHA measured in terms of polystyrene by GPC was 1,200. The obtained polymer was dissolved in PGMEA, and ion exchange was performed using a cation exchange resin and an anion exchange resin for 4 hours to obtain a target polymer solution.

DPAEHA has the following repeating units.

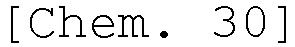

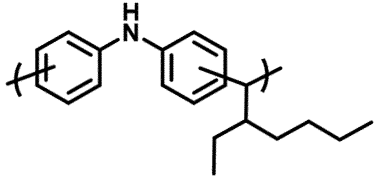

### [Synthesis Example 1-6]

86.36 g of 1,4-dioxane and 86.36 g of toluene were added to 56.02 g of 1-phenylnaphthylamine, 50.00 g of 1-pyrenecarboxaldehyde (manufactured by Maruzen Chemicals Co., Ltd.), 6.67 g of 4-(trifluoromethyl)benzaldehyde, and 2.46 g of methanesulfonic acid, and the mixture was stirred under reflux for 18 hours under a nitrogen atmosphere. After completion of the reaction, the mixture was diluted with 96 g of tetrahydrofuran, and the diluted solution was added dropwise to methanol to obtain a precipitate. The obtained precipitate was filtered, cleaned with methanol, and dried at 60°C for 24 hours to obtain a target polymer (hereinafter abbreviated as PPNAPCA-F).

The weight average molecular weight of PPNAPCA-F measured by GPC in terms of standard polystyrene was 1,100. The obtained polymer was dissolved in PGMEA, and ion exchange was performed using a cation exchange resin and an anion exchange resin for 4 hours to obtain a target polymer solution.

PPNAPCA-F has the following structural units in the following proportions:

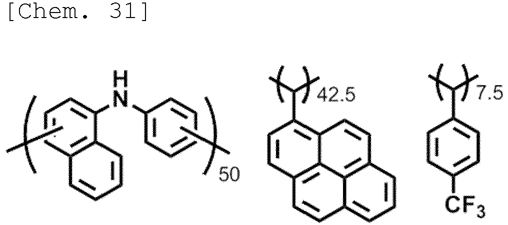

### [2] Preparation of Release Agent Composition

### [Preparation Example 2-1]

In a 50 mL screw vial, 0.92 g of the polymer solution obtained in Synthesis Example 1-1 (30% by mass PGMEA solution of PCzEHA), 2.76 g of a 10% by mass solution obtained by dissolving polymethyl methacrylic acid (Tg: 48°C, weight average molecular weight: 54,000, manufactured by FUJIFILM Wako Pure Chemical Corporation) in PGMEA, and further, 1.33 g of PGMEA as a solvent were added, and the mixture was stirred with a stirrer A for 5 minutes to obtain a release agent composition.

### [Preparation Example 2-2]

In a 50 mL screw vial, 3.01 g of the polymer solution obtained in Synthesis Example 1-2 (30% by mass PGMEA solution of PCzBA), 4.50 g of a 20% by mass solution obtained by dissolving polymethyl methacrylic acid (Tg: 48°C, weight average molecular weight: 54,000, manufactured by FUJIFILM Wako Pure Chemical Corporation) in PGMEA, and further, 2.50 g of PGMEA as a solvent were added, and the mixture was stirred with a stirrer A for 5 minutes to obtain a release agent composition.

### [Preparation Example 2-3]

In a 50 mL screw vial, 6.74 g of the polymer solution obtained in Synthesis Example 1-3 (30% by mass PGMEA solution of PCzNA), 11.26 g of a 20% by mass solution obtained by dissolving polymethyl methacrylic acid (Tg: 48°C, weight average molecular weight: 54,000, manufactured by FUJIFILM Wako Pure Chemical Corporation) in PGMEA, and further, 7.01 g of PGMEA as a solvent were added, and the mixture was stirred with a stirrer A for 5 minutes to obtain a release agent composition.

### [Preparation Example 2-4]

In a 50 mL screw vial, 3.03 g of the polymer solution obtained in Synthesis Example 1-4 (30% by mass PGMEA solution of PCzFL), 4.50 g of a 20% by mass solution obtained by dissolving polymethyl methacrylic acid (Tg: 48°C, weight average molecular weight: 54,000, manufactured by FUJIFILM Wako Pure Chemical Corporation) in PGMEA, and further, 2.51 g of PGMEA as a solvent were added, and the mixture was stirred with a stirrer A for 5 minutes to obtain a release agent composition.

### [Preparation Example 2-5]

In a 50 mL screw vial, 3.01 g of the polymer solution obtained in Synthesis Example 1-5 (30% by mass PGMEA solution of DPAEHA), 4.50 g of a 20% by mass solution obtained by dissolving polymethyl methacrylic acid (Tg: 48°C, weight average molecular weight: 54,000, manufactured by FUJIFILM Wako Pure Chemical Corporation) in PGMEA, and further, 2.51 g of PGMEA as a solvent were added, and the mixture was stirred with a stirrer A for 5 minutes to obtain a release agent composition.

### [Preparation Example 2-6]

In a 50 mL screw vial, 3.34 g of the polymer solution obtained in Synthesis Example 1-6 (30% by mass PGMEA solution of PPNAPCA-F), 4.51 g of a 20% by mass solution obtained by dissolving polymethyl methacrylic acid (Tg: 48°C, weight average molecular weight: 54,000, manufactured by FUJIFILM Wako Pure Chemical Corporation) in PGMEA, and further, 2.16 g of PGMEA as a solvent were added, and the mixture was stirred with a stirrer A for 5 minutes to obtain a release agent composition.

### [Comparative Preparation Example 2-1]

To a 50 mL screw vial, 4.08 g of the polymer solution obtained in Synthesis Example 1-1 (30% by mass PGMEA solution of PCzEHA) and 1.02 g of PGMEA as a solvent were added, and the mixture was stirred with a stirrer A for 5 minutes to obtain a release agent composition.

### [Comparative Preparation Example 2-2]

To a 50 mL screw vial, 10.00 g of the polymer solution obtained in Synthesis Example 1-3 (30% by mass PGMEA solution of PCzNA) and 6.70 g of PGMEA as a solvent were added, and the mixture was stirred with a stirrer A for 5 minutes to obtain a release agent composition.

### [Comparative Preparation Example 2-3]

To a 50 mL screw vial, 10.01 g of the polymer solution obtained in Synthesis Example 1-6 (30% by mass PGMEA solution of PPNAPCA-F) and 2.50 g of PGMEA as a solvent were added, and the mixture was stirred with a stirrer A for 5 minutes to obtain a release agent composition.

### [Comparative Preparation Example 2-4]

In a 50 mL screw vial, 6.60 g of the polymer solution obtained in Synthesis Example 1-1 (30% by mass PGMEA solution of PCzEHA), 2.01 g of polystyrene (manufactured by Sigma-Aldrich), and 20.00 g of PGMEA as a solvent were added, and the mixture was stirred with a stirrer A for 5 minutes to obtain a release agent composition.

### [Comparative Preparation Example 2-5]

To a 50 mL screw vial, 6.68 g of the polymer solution obtained in Synthesis Example 1-1 (30% PGMEA solution of PCzEHA), 2.00 g of polyhydroxystyrene, and further 20.01 g of PGMEA as a solvent were added, and the mixture was stirred with a stirrer A for 5 minutes to obtain a release agent composition.

### [Comparative Preparation Example 2-6]

In a 50 mL screw vial, 1.25 g of a solution obtained by dissolving the dried polymer obtained in Synthesis Example 1-1 in mesitylene (30% by mass mesitylene solution of PCzEHA) and 3.75 g of a solution obtained by dissolving SEPTON4033 (manufactured by Kuraray Co., Ltd.) in mesitylene (10% by mass mesitylene solution of SEPTON4033) were added, and the mixture was stirred with a stirrer A for 5 minutes to obtain a release agent composition.

In addition, SEPTON4033 is a hydrogenated styrene thermoplastic elastomer and does not have a (meth)acrylic acid ester unit.

### [3] Preparation of Adhesive Composition

### [Preparation Example 3]

In a 600 mL stirring vessel dedicated to a planetary centrifugal mixer, 104.14 g of a p-menthane solution (concentration: 80.6% by mass) of an MQ resin (manufactured by Wacker Chemie AG) having a polysiloxane skeleton and a vinyl group as the component (a1), 58.11 g of polyorganosiloxane (manufactured by Wacker Chemie AG, trade name AK1000000, viscosity 1,000,000 mm2/s) as the component (B), 34.94 g of p-menthane (manufactured by Nippon Terpene Chemicals, Inc.) as a solvent, and 6.20 g of n-decane (manufactured by Sankyo Chemical Co., Ltd.) were added and stirred with a stirrer A for 5 minutes to obtain a mixture (I).

16.79 g of SiH group-containing linear polydimethylsiloxane (manufactured by Wacker Chemie AG) having a viscosity of 100 mPa·s as the component (a2) and 24.54 g of vinyl group-containing linear polydimethylsiloxane (manufactured by Wacker Chemie AG) having a viscosity of 200 mPa·s as the component (a1) were added to the obtained mixture (I) to obtain a mixture (II).

1.61 g of 1,1 diphenyl-2-propyn-1-ol (manufactured by Tokyo Chemical Industry Co., Ltd.) and 1.61 g of 1-ethynyl-1-cyclohexanol (manufactured by Wacker Chemie AG) as the component (A3) and 3.23 g of p-menthane (manufactured by Nippon Terpene Chemicals, Inc.) as a solvent were stirred with the stirrer for 60 minutes to obtain a mixture (III).

1.29 g of the obtained mixture (III) was added to the mixture (II), and the mixture was stirred with the stirrer for 5 minutes to obtain a mixture (IV).

0.65 g of a platinum catalyst (manufactured by Wacker Chemie AG) as the component (A2) and 19.37 g of vinyl group-containing linear polydimethylsiloxane (manufactured by Wacker Chemie AG) having a viscosity of 1,000 mPa·s as the component (a1) were stirred with a stirrer A for 5 minutes to obtain a mixture (V).

4.00 g of the obtained mixture (V) was added to the mixture (IV), and the mixture was stirred with a stirrer A for 5 minutes to obtain a mixture (VI).

Finally, the obtained mixture (VI) was filtered through a nylon filter 300 mesh to obtain an adhesive composition. In addition, the viscosity of the obtained adhesive composition was 3,000 mPa·s.

### [4] Preparation of Cleaning Agent Composition

### [Preparation Example 4]

95 g of N,N-dimethylpropionamide was added to 5 g of Tetrabutylammonium fluoride trihydrate (manufactured by KANTO CHEMICAL CO., INC.), and the obtained mixture was stirred to obtain a cleaning agent composition.

### [5] Coating Property Test

### [Examples 1-1 to 1-6 and Comparative Examples 1-1 to 1-6]

A 100 mm silicon wafer (thickness: 770 µm) as a device-side wafer (semiconductor substrate) is coated with the releasable composition obtained in Preparation Examples 2-1 to 2-6 and Comparative Preparation Examples 2-1 to 2-6 by spin coating, and heated at 200°C for 5 minutes to form a release agent layer on the silicon wafer such that the final thickness of the release agent layer was approximately 1,500 nm.

For the evaluation of coatability, the case where no cracks or liquid crawling was confirmed in the release agent layer applied on a silicon wafer was evaluated as "○", and the case where cracks or liquid crawling was confirmed was evaluated as "×". The evaluation results of the coatability were as shown in Table 1 below.

In addition, even when a device wafer having a bump having a height of 30 to 40 µm was used as the device-side wafer, the same coatability was obtained.

**[Table 1]**

| | Composition used in release agent layer | Polymer ratio (mass ratio) | Coatability |
|---|---|---|---|
| Example 1-1 | Preparation Example 2-1 | PCzEHA: PMMA =50:50 | ○ |
| Example 1-2 | Preparation Example 2-2 | PCzBA: PMMA =50:50 | ○ |
| Example 1-3 | Preparation Example 2-3 | PCzNA: PMMA =47:53 | ○ |
| Example 1-4 | Preparation Example 2-4 | PCzFL: PMMA =50:50 | ○ |
| Example 1-5 | Preparation Example 2-5 | DPAEHA: PMMA =50:50 | ○ |
| Example 1-6 | Preparation Example 2-6 | PPNAPCA-F: PMMA =53:47 | ○ |
| Comparative Example 1-1 | Comparative Preparation Example 2-1 | PCzEHA 100% | × |
| Comparative Example 1-2 | Comparative Preparation Example 2-2 | PCzNA 100% | × |
| Comparative Example 1-3 | Comparative Preparation Example 2-3 | PPNAPCA-F 100% | × |
| Comparative Example 1-4 | Comparative Preparation Example 2-4 | PCzEHA:PSt =50:50 | × |
| Comparative Example 1-5 | Comparative Preparation Example 2-5 | PCzEHA:PHSt =50:50 | ○ |
| Comparative Example 1-6 | Comparative Preparation Example 2-6 | PCzEHA: SEPTON 4033 =50:50 | ○ |

In Table 1, PMMA represents polymethyl methacrylic acid. PSt represents polystyrene. PHSt represents polyhydroxystyrene.

### [5] Releasability Test

### [5-1] Preparation of Laminate

### [Example 2-1]

A 100 mm silicon wafer (thickness: 770 µm) as a device-side wafer (semiconductor substrate) was coated with the release agent composition obtained in Preparation Example 2-1 by spin coating, and heated at 200°C for 5 minutes to form a release agent layer on the silicon wafer such that the final thickness of the release agent layer in the laminate was approximately 1,500 nm. Thereafter, the silicon wafer on which the release agent layer had been formed was coated with the adhesive composition obtained in Preparation Example 3 by spin coating, and heated (preheat treatment) at 120°C for 1.5 minutes to form an adhesive coating layer such that the final thickness of the adhesive layer in the laminate was approximately 60 µm. Thereafter, in a vacuum bonding apparatus, a semiconductor substrate and a 100 mm glass wafer (thickness: 500 µm) as a support substrate were bonded to sandwich the adhesive coating layer and the release agent layer, and heated on a hot plate at 200°C for 10 minutes with the semiconductor substrate side facing down (post-heat treatment) to prepare a laminate. In addition, bonding was performed at a temperature of 23°C and a degree of vacuum of 1,000 Pa.

### [Examples 2-2 to 2-6 and Comparative Examples 2-1 and 2-2]

A laminate was produced in the same manner as in Example 2-1, except that the release agent compositions obtained in Preparation Examples 2-2 to 2-6 and Comparative Preparation Examples 2-5 and 2-6 were used instead of the release agent composition obtained in Preparation Example 2-1.

### [5-2] Evaluation of Laser Releasability

Using a laser irradiation apparatus, the release agent layer was irradiated with a laser having a wavelength of 308 nm at 120 mJ/cm² from the glass wafer side of the fixed laminate. Then, the support substrate was manually lifted to confirm whether or not releasing was possible. In the evaluation of the releasability, the case where releasing could be performed without a load by lifting the support substrate was evaluated as "○", and the case where a load was applied to releasing was evaluated as "×". The results are shown in Table 2.

In addition, even when a device wafer having a bump with a height of 30 to 40 µm was used as a device-side wafer, the same releasability was obtained.

**[Table 2]**

| | Composition used in release agent layer | Releasability |
|---|---|---|
| Example 2-1 | Preparation Example 2-1 | ○ |
| Example 2-2 | Preparation Example 2-2 | ○ |
| Example 2-3 | Preparation Example 2-3 | ○ |
| Example 2-4 | Preparation Example 2-4 | ○ |
| Example 2-5 | Preparation Example 2-5 | ○ |
| Example 2-6 | Preparation Example 2-6 | ○ |
| Comparative Example 2-1 | Comparative Preparation Example 2-5 | ○ |
| Comparative Example 2-2 | Comparative Preparation Example 2-6 | × |

### [6] Cleanability Test

### [Examples 3-1 to 3-6 and Comparative Example 3-1]

The device-side wafer (semiconductor substrate) after laser releasing obtained in Examples 2-1 to 2-6 and Comparative Example 2-1 was cut into a 4 cm square chip, placed in a stainless steel petri dish having a diameter of 9 cm, added with 7 mL of the cleaning agent composition obtained in Preparation Example 4, covered with a lid, then placed on a stirrer H, and stirred and cleaned at 23°C for 5 minutes.

After cleaning, the chip was taken out, cleaned with isopropanol and pure water, and dried at 120°C for 1 minute. Thereafter, the case where the residue of the adhesive composition or the release agent composition was not confirmed on the device wafer was evaluated as "○", and the case where the residue was confirmed was evaluated as "×". The results are shown in Table 3.

In addition, even when a device wafer having a bump with a height of 30 to 40 µm was used as a device-side wafer, the same cleanability was obtained.

**[Table 3]**

| | Composition used in release agent layer | Cleanability |
|---|---|---|
| Example 3-1 | Preparation Example 2-1 | ○ |
| Example 3-2 | Preparation Example 2-2 | ○ |
| Example 3-3 | Preparation Example 2-3 | ○ |
| Example 3-4 | Preparation Example 2-4 | ○ |
| Example 3-5 | Preparation Example 2-5 | ○ |
| Example 3-6 | Preparation Example 2-6 | ○ |
| Comparative Example 3-1 | Comparative Preparation Example 2-5 | × |

### Reference Signs List

- 1: Semiconductor Substrate
- 1a: Bump
- 2: Release Agent Layer
- 3: Adhesive Layer
- 3a: Adhesive Coating Layer
- 4: Support Substrate
- 21: Semiconductor Chip Substrate
- 22: Adhesive Layer
- 23: Release Agent Layer
- 24: Support Substrate
- 25: Sealing Resin
- 26: Electronic Device Layer
- 27: Release Agent Layer Having Adhesive Performance
- 28: Wiring Layer

## Claims

1. A release agent composition for photoirradiation release, comprising:
a Novolac resin, a (meth)acrylic acid ester-based polymer, and a solvent.

2. The release agent composition according to claim 1, wherein the (meth)acrylic acid ester-based polymer contains a repeating unit derived from a (meth)acrylic acid alkyl ester having 4 to 20 carbon atoms.

3. The release agent composition according to claim 1, wherein the (meth)acrylic acid ester-based polymer contains a repeating unit derived from methyl methacrylate.

4. The release agent composition according to claim 1, wherein the (meth)acrylic acid ester-based polymer contains polymethyl methacrylate.

5. The release agent composition according to claim 1, wherein the Novolac resin contains at least one of a structural unit represented by Formula (C1-1) below, a structural unit represented by Formula (1-2) below, and a structural unit represented by Formula (C1-3) below, 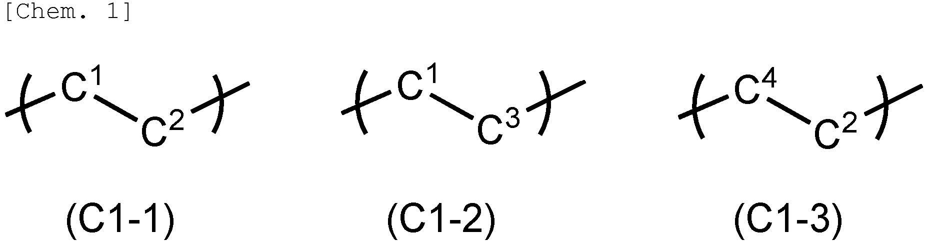 in the formula, C¹ represents a group derived from an aromatic compound containing a nitrogen atom, C² represents a group containing a tertiary carbon atom or a quaternary carbon atom having at least one selected from a group consisting of a secondary carbon atom, a quaternary carbon atom, and an aromatic ring in a side chain, or represents a methylene group, C³ represents a group derived from an aliphatic polycyclic compound, and C⁴ represents a group derived from phenol, a group derived from bisphenol, a group derived from naphthol, a group derived from biphenyl, or a group derived from biphenol.

6. The release agent composition according to claim 5, wherein the Novolac resin contains, as the structural unit represented by the Formula (C1-1), at least one of a structural unit represented by Formula (C1-1-1) below and a structural unit represented by Formula (C1-1-2) below, 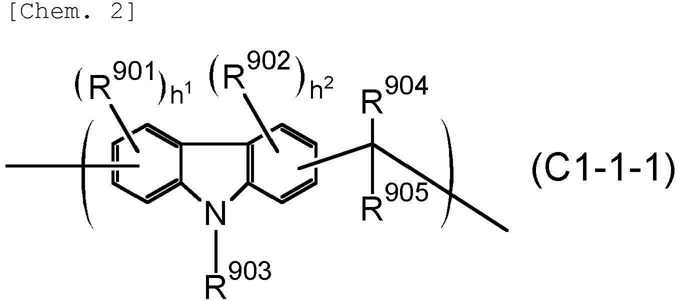 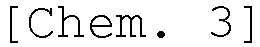 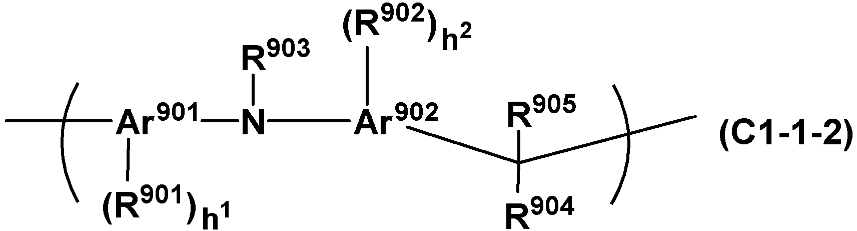
in the Formulas (C1-1-1) and (C1-1-2), R⁹⁰¹ and R⁹⁰² represent a substituent substituted with a ring, and each independently represent a halogen atom, a nitro group, a cyano group, an amino group, a hydroxy group, a carboxy group, an optionally substituted alkyl group, an optionally substituted alkenyl group, or an optionally substituted aryl group,
R⁹⁰³ represents a hydrogen atom, an optionally substituted alkyl group, an optionally substituted alkenyl group, or an optionally substituted aryl group,
R⁹⁰⁴ represents a hydrogen atom, an optionally substituted aryl group, or an optionally substituted heteroaryl group,
R⁹⁰⁵ represents an optionally substituted alkyl group, an optionally substituted aryl group, or an optionally substituted heteroaryl group,
the group of R⁹⁰⁴ and the group of R⁹⁰⁵ may be bonded to each other to form a divalent group,
Ar⁹⁰¹ and Ar⁹⁰² each independently represent an aromatic ring,
h¹ and h² each independently represent an integer of 0 to 3.

7. The release agent composition according to claim 1, wherein a content of the (meth)acrylic acid ester-based polymer is 35% by mass or more with respect to a total of the Novolac resin and the (meth)acrylic acid ester-based polymer.

8. A laminate comprising:
a semiconductor substrate or an electronic device layer;
a light-transmissive support substrate; and
a release agent layer provided between the semiconductor substrate or the electronic device layer and the support substrate, wherein
the release agent layer is a release agent layer formed from the release agent composition according to any one of claims 1 to 7.

9. The release agent composition according to claim 8, wherein the release agent layer has a thickness of 0.5 µm to 10 um.

10. The laminate according to claim 8, further comprising an adhesive layer provided between the semiconductor substrate or the electronic device layer and the support substrate.

11. The laminate according to claim 8, wherein the release agent layer is in contact with the semiconductor substrate.

12. The laminate according to claim 8, wherein a surface of the semiconductor substrate on the support substrate side has a bump.

13. A method for producing a processed semiconductor substrate or an electronic device layer, the method comprising:
Step 5A of processing the semiconductor substrate of the laminate according to claim 8, or Step 5B of processing the electronic device layer of the laminate according to claim 8; and
Step 6A of separating the semiconductor substrate processed in the Step 5A and the support substrate from each other, or Step 6B of separating the electronic device layer processed in the Step 5B and the support substrate from each other.

14. The method for producing a processed semiconductor substrate or an electronic device layer according to claim 13, wherein the Step 6A or the Step 6B includes a step of irradiating the laminate with a laser from the support substrate side.
